# EUROPEAN PATENT APPLICATION

(11) **EP 4 181 655 A1**
(43) Date of publication of application: **17.05.2023**
(21) Application number: 22205057.7
(22) Date of filing: 02.11.2022
(51) Int. Cl.: H10K 85/60, H10K 50/10

(54) **ORGANIC LIGHT EMITTING ELEMENT**

(30) Priority: 10.11.2021 KR 20210154301
(71) Applicant: LG Display Co., Ltd., SEOUL, 07336 (KR)
(72) Inventor: YOO, Seonkeun, 10845 Paju-si (KR); YU, Youngjun, 10845 Paju-si (KR); KIM, SangBeom, 10845 Paju-si (KR)
(74) Representative: Viering, Jentschura & Partner mbB Patent- und Rechtsanwälte

(57) **Abstract**

Embodiments of the disclosure relate to an organic light emitting element (100, 200, 300, 400). Specifically, there may be provided an organic light emitting element (100, 200, 300, 400) having high efficiency or long lifespan by including a first electrode (110), a second electrode (120), and an organic material layer (130) positioned therebetween wherein the organic material layer (130) includes a specific compound.

## Description

### CROSS-REFERENCE TO RELATED APPLICATION

This application claims priority from Korean Patent Application No. 10-2021-0154301, filed on November 10, 2021.

### BACKGROUND

### Technical Field

Embodiments of the disclosure relate to an organic light emitting element.

### Discussion of the Related Art

In general, organic light emission refers to a phenomenon in which electric energy is converted into light energy by an organic material. The organic light emitting element refers to a light emitting element using the organic light emission phenomenon. The organic light emitting element has a structure including an anode, a cathode, and an organic material layer disposed therebetween.

The organic material layer may have a multilayer structure composed of different materials to increase the efficiency and stability of the organic light emitting element and may include a light emitting layer (also referred to as an emission material layer (EML)).

The lifespan and efficiency are the most important issues with organic light emitting elements. The efficiency, lifespan, and driving voltage are related to each other. If the efficiency is increased, the driving voltage is relatively decreased, so that the crystallization of the organic material by the Joule heating during driving is reduced, leading to an increase in lifespan.

The role of the light emitting layer EML is important to enhance the light emitting properties of the organic light emitting element and increase the lifespan. In particular, to have high-efficiency characteristics, the host material of the light emitting layer is required to have a high triplet level, and the stability of the material is needed.

### BRIEF SUMMARY

In order for the organic light emitting element to sufficiently exhibit its excellent characteristics, the materials constituting the organic material layer should be stable and have excellent efficiency. Since the phosphorescent organic light emitting element has a greater hole mobility than electron mobility in the light emitting layer and a long triplet state lifespan, excitons formed in the light emitting layer are distributed over a wide area, so that the light emission may be reduced. Accordingly, the inventors of the disclosure have invented an organic light emitting element that may have excellent efficiency or long lifespan.

Accordingly, embodiments of the present disclosure are directed to an organic light emitting element that substantially obviates one or more of the problems due to limitations and disadvantages of the related art.

An aspect of the present disclosure is to provide an organic light emitting element having high efficiency or long lifespan.

According to an aspect of the present disclosure there is provided an organic light emitting element including a first electrode, a second electrode, and an organic material layer positioned between the first electrode and the second electrode.

The organic material layer comprises a compound represented by chemical formula 1 below:

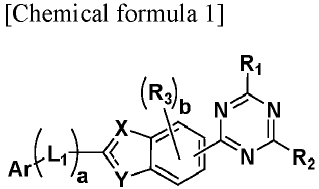

According to embodiments of the present disclosure, in chemical formula 1,
either X or Y is N, and the other is S or O, wherein
R₁ and R₂ are each independently selected from the group consisting of a C₆-C₆₀ aryl group; a fluorenyl group; and a C₂-C₆₀ heterocyclic group including at least one heteroatom of O, N, S, Si, and P,
b is an integer from 0 to 3,
R₃ is each independently a C₁-C₂₀ alkyl group; or C₆-C₆₀ aryl group,
a is an integer from 0 to 2,
L₁ is each independently selected from the group consisting of a single bond; a fluorenylene group; and a C₆-C₆₀ arylene group,
Ar is selected from the group consisting of hydrogen; halogen; a cyano group; a C₁-C₂₀ alkyl group; a fluorenyl group; a C₆-C₆₀ aryl group; and a C₂-C₆₀ heterocyclic group including at least one heteroatom of O, N, S, Si and P, and
the aryl group, the heterocyclic group, the arylene group, and the alkyl group each are further substituted with one or more substituents selected from the group consisting of a halogen group; a C₁-C₂₀ alkyl group; a C₂-C₂₀ alkenyl group; a C₂-C₂₀ alkynyl group; a fluorenyl group; a C₆-C₂₀ aryl group; and a C₂-C₂₀ heterocyclic group.

Further embodiments of the present disclosure are described in the dependent claims.

According to embodiments of the disclosure, there may be provided an organic light emitting element having high efficiency or long lifespan.

It is to be understood that both the foregoing general description and the following detailed description are exemplary and explanatory and are intended to provide further explanation of the inventive concepts as claimed.

### BRIEF DESCRIPTION OF DRAWINGS

The accompanying drawings, which are included to provide a further understanding of the disclosure and are incorporated in and constitute a part of this application, illustrate embodiments of the disclosure and together with the description serve to explain various principles. In the drawings:
FIGS. 1 and 2 are views schematically illustrating an organic light emitting element according to embodiments of the disclosure;
FIG. 3 is a view schematically illustrating an organic light emitting element according to embodiments of the disclosure; and
FIG. 4 is a view schematically illustrating an organic light emitting element according to embodiments of the disclosure.

### DETAILED DESCRIPTION

In the following description of examples or embodiments of the disclosure, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the disclosure, detailed descriptions of well-known functions and components incorporated herein will be omitted when it is determined that the description may make the subject matter in some embodiments of the disclosure rather unclear. The terms such as "including", "having", "containing", "constituting" "make up of', and "formed of' used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the disclosure. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe nonconsecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, various embodiments of the disclosure are described in detail with reference to the accompanying drawings.

As used herein, the term "halo" or "halogen" includes fluorine (F), chlorine (Cl), bromine (Br), and iodine (I), and the like, unless otherwise specified.

As used herein, the term "alkyl" or "alkyl group" may mean a radical of a saturated aliphatic functional group having 1 to 60 carbon atoms linked by a single bond and including a straight chain alkyl group, branched chain alkyl group, cycloalkyl (alicyclic) group, alkylsubstituted cycloalkyl group, or cycloalkyl-substituted alkyl group, unless otherwise specified.

As used herein, the term "haloalkyl group" or "halogen alkyl group" may mean a halogen-substituted alkyl group unless otherwise specified.

As used herein, the term "alkenyl" or "alkynyl" may have a double bond or a triple bond, respectively, and may include a straight or branched chain group and may have 2 to 60 carbon atoms unless otherwise specified.

As used herein, the term "cycloalkyl" may refer to an alkyl forming a ring having 3 to 60 carbon atoms, unless otherwise specified.

As used herein, the term "alkoxy group" or "alkyloxy group" refers to an alkyl group to which an oxygen radical is bonded, and may have 1 to 60 carbon atoms unless otherwise specified.

As used herein, the term "alkenoxyl group", "alkenoxy group", "alkenyloxyl group", or "alkenyloxy group" refers to an alkenyl group to which an oxygen radical is attached, and may have 2 to 60 carbon atoms unless otherwise specified.

As used herein, the terms "aryl group" and "arylene group" each may have 6 to 60 carbon atoms unless otherwise specified, but are not limited thereto. In the disclosure, the aryl group or the arylene group may include a monocyclic type, a ring assembly, a fused polycyclic system, a spiro compound, and the like. For example, the aryl group includes, but is not limited to, phenyl, biphenyl, naphthyl, anthryl, indenyl, phenanthryl, triphenylenyl, pyrenyl, peryleneyl, chrysenyl, naphthacenyl, or fluoranthenyl. The naphthyl may include 1-naphthyl and 2-naphthyl, and the anthryl may include 1-anthryl, 2-anthryl and 9-anthryl.

In the disclosure, the term "fluorenyl group" or "fluorenylene group" may refer to a monovalent or divalent functional group, respectively, of fluorene, unless otherwise specified. The "fluorenyl group" or "fluorenylene group" may mean a substituted fluorenyl group or a substituted fluorenylene group. "Substituted fluorenyl group" or "substituted fluorenylene group" may refer to a monovalent or divalent functional group of substituted fluorene. "Substituted fluorene" may mean that at least one of the following substituents R, R', R" and R‴ is a functional group other than hydrogen. It may include a case where R and R' are bonded to each other to form a spiro compound together with the carbon to which they are bonded.

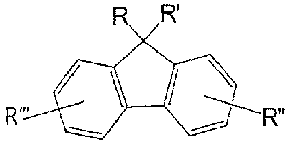

As used herein, the term "spiro compound" has a 'spiro union', and the spiro union means a union formed as two rings share only one atom. In this case, the atom shared by the two rings may be referred to as a 'spiro atom'.

As used herein, the term "heterocyclic group" may include not only an aromatic ring, such as a "heteroaryl group" or "heteroarylene group" but also a non-aromatic ring and, unless otherwise specified, means a ring with 2 to 50 carbon atoms and one or more heteroatoms, but is not limited thereto. As used herein, the term "heteroatom" refers to N, O, S, P or Si unless otherwise specified, and the heterocyclic group may mean a monocyclic group containing a heteroatom, a ring assembly, a fused polycyclic system, or a spyro compound.

The "heterocyclic group" may include a ring containing SO2 instead of carbon forming the ring. For example, the "heterocyclic group" may include the following compounds.

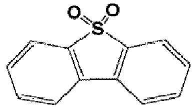

As used herein, the term "ring" may include monocycles and polycycles, may include hydrocarbon rings as well as heterocycles containing at least one heteroatom, or may include aromatic and non-aromatic rings.

As used herein, the term "polycycle" may include ring assemblies, fused polycyclic systems, and spiro compounds, may include aromatic as well as non-aromatic compounds, or may include heterocycles containing at least one heteroatom as well as hydrocarbon rings.

As used herein, the term "aliphatic ring group" refers to a cyclic hydrocarbon other than the aromatic hydrocarbon, may include a monocyclic type, a ring assembly, a fused polycyclic system, and a spiro compound and, unless otherwise specified, may mean a ring having 3 to 60 carbon atoms. For example, a fusion of benzene, which is an aromatic ring, and cyclohexane, which is a non-aromatic ring, also corresponds to an aliphatic ring.

As used herein, the term "alkyl silyl group" may refer to a monovalent substituent in which three alkyl groups are bonded to a Si atom.

As used herein, the term "aryl silyl group" may refer to a monovalent substituent in which three aryl groups are bonded to a Si atom.

As used herein, the term "alkyl aryl silyl group" may refer to a monovalent substituent in which one alkyl group and two aryl groups are bonded to a Si atom or two alkyl groups and one aryl group are bonded to the Si atom.

As used herein, the term "ring assembly" means that two or more ring systems (single or fused ring systems) are directly connected to each other through single or double bonds. For example, in the case of an aryl group, a biphenyl group or a terphenyl group may be a ring assembly but is not limited thereto.

As used herein, the term "fused polycyclic system" refers to a type of fused rings sharing at least two atoms. For example, in the case of an aryl group, a naphthalenyl group, a phenanthrenyl group, or a fluorenyl group may be a fused polycyclic system, but is not limited thereto.

When prefixes are named successively, it may mean that the substituents are listed in the order specified first. For example, an arylalkoxy group may mean an alkoxy group substituted with an aryl group, an alkoxycarbonyl group may mean a carbonyl group substituted with an alkoxy group, and an arylcarbonylalkenyl group may mean an alkenyl group substituted with an arylcarbonyl group. The arylcarbonyl group may be a carbonyl group substituted with an aryl group.

Unless otherwise explicitly stated, in the term "substituted" or "unsubstituted" as used herein, "substituted" may mean being substituted with one or more substituents selected from the group consisting of halogen, an amino group, a nitrile group, a nitro group, a C₁-C₂₀ alkyl group, a C₁-C₂₀ alkoxy group, a C₁-C₂₀ alkylamine group, a C₁-C₂₀ alkylthiophene group, a C₆-C₂₀ arylthiophene group, a C₂-C₂₀ alkenyl group, a C₂-C₂₀ alkynyl group, a C₃-C₂₀ cycloalkyl group, a C₆-C₂₀ aryl group, a C₈-C₂₀ arylalkenyl group, a silane group, a boron group, a germanium group, and a C₂-C₂₀ heterocyclic group including at least one heteroatom selected from the group consisting of O, N, S, Si and P, but is not limited to the substituents.

In the disclosure, the 'functional group names' corresponding to the aryl group, arylene group, and heterocyclic group provided as examples of the symbols and their substituents may be described with 'the names of the functional groups reflecting the valence', but may also be described with 'the names of the parent compounds.' For example, in the case of'phenanthrene', which is a type of aryl group, its name may be specified with its group identified, such as 'phenanthryl (group)' for the monovalent group, and 'phenanthrylene (group)' as the divalent group, but may also be specified as 'phenanthrene', which is the name of the parent compound, regardless of the valence. Similarly, pyrimidine may be specified as 'pyrimidine' regardless of the valence or may also be specified as pyrimidinyl (group) for the monovalence and as pyrimidylene (group) for the divalence. Therefore, in the disclosure, when the type of the substituent is specified with the name of the parent compound, it may mean an n-valent 'group' formed by detachment of the hydrogen atom bonded to a carbon atom and/or a heteroatom of the parent compound.

Further, unless explicitly stated, the formulas used in the disclosure may be applied in the same manner as the definition of the substituent by the following formulas.

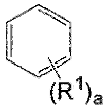

When a is 0, it means that the substituent R₁ does not exist, meaning that hydrogen is bonded to each of the carbon atoms forming the benzene ring. In this case, the chemical formula or chemical compound may be specified without expressing the hydrogen bonded to the carbon. Further, when a is 1, one substituent R₁ is bonded to any one of the carbon atoms forming the benzene ring, and when a is 2 or 3, it may be bonded as follows. When a is an integer of 4 to 6, it is bonded to the carbon of the benzene ring in a similar manner, and when a is an integer of 2 or more, R₁ may be identical or different.

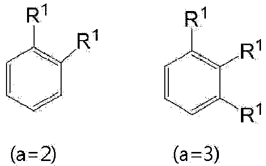

In the disclosure, when substituents are bonded to each other to form a ring, it may mean that adjacent groups are bonded to each other to form a monocycle or fused polycycle, and the monocycle or fused polycycle may include heterocycles containing at least one heteroatom as well as hydrocarbon rings and may include aromatic and non-aromatic rings.

In the disclosure, organic light emitting element may mean a component(s) between the anode and the cathode or an organic light emitting diode including an anode, a cathode, and component(s) positioned therebetween.

In some cases, in the disclosure, organic light emitting element may mean an organic light emitting diode and a panel including the same, or an electronic device including the panel and circuitry. The electronic device may include, e.g., a display device, a lighting device, a solar cell, a portable or mobile terminal (e.g., a smart phone, a tablet, a PDA, an electronic dictionary, or PMP), a navigation terminal, a game device, various TVs, and various computer monitors but, without limited thereto, may include any type of device including the component(s).

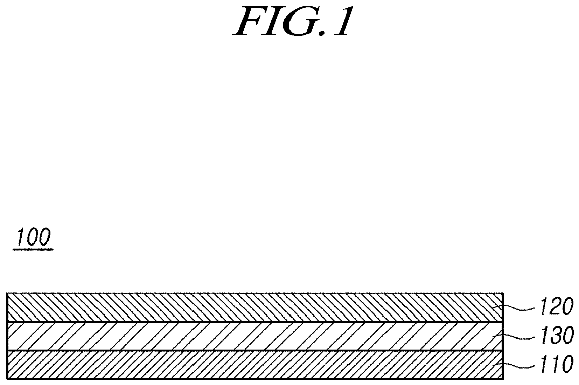

FIG. 1 is a view schematically illustrating an organic light emitting element according to embodiments of the disclosure.

The organic light emitting element 100 according to embodiments of the disclosure includes a first electrode 110, a second electrode 120, and an organic material layer 130 positioned between the first electrode 110 and the second electrode 120.

For example, the first electrode 110 may be the anode electrode, and the second electrode 120 may be the cathode electrode.

For example, the first electrode 110 may be a transparent electrode, and the second electrode 130 may be a reflective electrode. In another example, the first electrode 110 may be a reflective electrode, and the second electrode 130 may be a transparent electrode.

The organic material layer 130 is a layer positioned between the first electrode 110 and the second electrode 120 and including an organic material and may be composed of a plurality of layers.

The organic material layer 130 includes a compound represented by chemical formula 1. The compound represented by chemical formula 1 is described below in detail.

The organic material layer 130 may include a light emitting layer. The organic layer 130 may further include at least one of a hole injection layer, a hole transport layer, an electron transport layer, and an electron injection layer.

For example, the organic material layer 130 may include a hole injection layer positioned on the first electrode 110, a hole transport layer positioned on the hole injection layer, a light emitting layer positioned on the hole transport layer, an electron transport layer positioned on the light emitting layer, and an electron injection layer positioned on the electron transport layer. In such an example, the first electrode 110 may be the anode electrode, and the second electrode 120 may be the cathode electrode.

The light emitting layer is a layer in which as holes and electrons transferred from the first electrode 110 and the second electrode 130 meet to emit light and may include, e.g., a host material and a dopant.

The light emitting layer may include the compound represented by chemical formula 1 described above. The compound represented by chemical formula 1 may be the host compound of the light emitting layer. For example, the compound represented by chemical formula 1 may be a phosphorescent host compound of the light emitting layer.

The light emitting layer may further include a host compound different from the compound represented by chemical formula 1 described above. The type of the host compound that may be additionally included is not particularly limited, and a known host compound may be used.

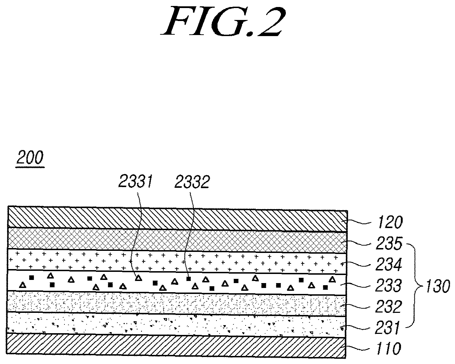

FIG. 2 is a view schematically illustrating an organic light emitting element according to embodiments of the disclosure.

The organic light emitting element 200 according to embodiments of the disclosure includes a first electrode 110, a second electrode 120, and an organic material layer 130 positioned between the first electrode 110 and the second electrode 120.

For example, the first electrode 110 may be the anode electrode, and the second electrode 120 may be the cathode electrode.

For example, the first electrode 110 may be a transparent electrode, and the second electrode 120 may be a reflective electrode. In another example, the first electrode 110 may be a reflective electrode, and the second electrode 120 may be a transparent electrode.

The organic material layer 130 is a layer positioned between the first electrode 110 and the second electrode 120 and including an organic material and may be composed of a plurality of layers.

The organic material layer 130 includes a compound represented by chemical formula 1. The compound represented by chemical formula 1 is described below in detail.

The organic material layer 130 may include a hole injection layer 231 positioned on the first electrode 110, a hole transport layer 232 positioned on the hole injection layer 231, a light emitting layer 233 positioned on the hole transport layer 232, an electron transport layer 234 positioned on the light emitting layer 233, and an electron injection layer 235 positioned on the electron transport layer 234. In such an example, the first electrode 110 may be the anode electrode, and the second electrode 120 may be the cathode electrode. The organic material layer 130 may not include some of the layers shown in FIG. 2 or may include an additional functional layer, such as a light emitting assist layer.

The light emitting layer 233 may include the compound represented by chemical formula 1 described above.

The light emitting layer 233 may include a host compound 2331 and a dopant 2332. The host compound 2331 may be a compound represented by chemical formula 1 described above. The host compound 2331 may further include another compound different from the compound represented by chemical formula 1 described above. For example, the host compound 2331 may include a compound represented by chemical formula 1 and a biscarbazole-based compound.

The type of the dopant 2332 is not particularly limited. For example, the dopant 2332 may be a green phosphorescent dopant. For example, the dopant 2332 may be a metal complex, such as of iridium.

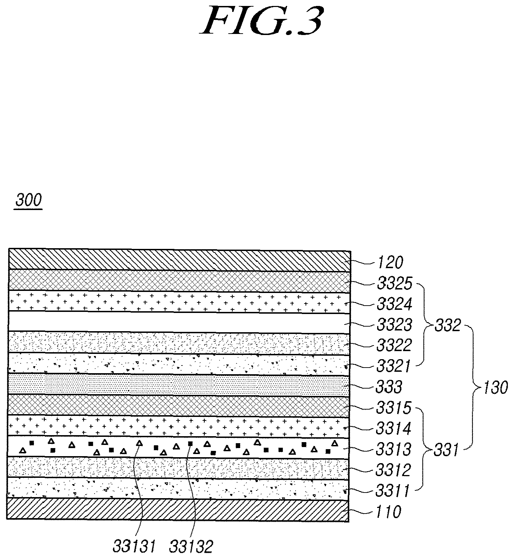

FIG. 3 is a view schematically illustrating an organic light emitting element according to embodiments of the disclosure.

Referring to FIG. 3, the organic material layer 130 includes a first stack 331, a second stack 332, and a charge generation layer 333 positioned between the first stack 331 and the second stack 332.

The organic light emitting element 300 may be a tandem-type organic light emitting element including a plurality of stacks each including a light emitting layer. The plurality of light emitting layers may be formed of the same material or different materials. The first stack 331 may include a first light emitting layer 3313. The second stack 332 may include a second light emitting layer 3323. The first light emitting layer 3313 and the second light emitting layer 3323 may be formed of the same material or different materials.

The first stack 331 may include a first light emitting layer 3313. The first light emitting layer 3313 may include, e.g., a first host compound 33131 and a first dopant 33132.

The first stack 331 may further include at least one of a hole injection layer, a hole transport layer, an electron transport layer, and an electron injection layer.

For example, the first stack 331 may include a first hole injection layer 3311 positioned on the first electrode 110, a first hole transport layer 3312 positioned on the first hole injection layer 3311, a first light emitting layer 3313 positioned on the first hole transport layer 3312, a first electron transport layer 3314 positioned on the first light emitting layer 3313, and a first electron injection layer 3315 positioned on the first electron transport layer 3314. In such an example, the first electrode 110 may be the anode electrode, and the second electrode 120 may be the cathode electrode. The first stack 331 may not include some of the layers shown in FIG. 3 or may include an additional functional layer, such as a light emitting assist layer.

The first light emitting layer 3313 may include the compound represented by chemical formula 1 described above.

The first light emitting layer 3313 may include a first host compound 33131 and a first dopant 33132. The first host compound 33131 may be a compound represented by chemical formula 1 described above. The first host compound 33131 may further include another compound different from the compound represented by chemical formula 1 described above. For example, the first host compound 33131 may include a compound represented by chemical formula 1 and a biscarbazole-based compound.

The type of the first dopant 33132 is not particularly limited. For example, the first dopant 33132 may be a green phosphorescent dopant. For example, the first dopant 33132 may be a metal complex, such as of iridium.

The second stack 332 may include a second light emitting layer 3323. The second light emitting layer 3323 may include, e.g., a second host compound and a second dopant.

The second stack 332 may further include at least one of a hole injection layer, a hole transport layer, an electron transport layer, and an electron injection layer.

For example, the second stack 332 may include a second hole injection layer 3321 positioned on the second electrode 110, a second hole transport layer 3322 positioned on the second hole injection layer 3321, a second light emitting layer 3323 positioned on the second hole transport layer 3322, a second electron transport layer 3324 positioned on the second light emitting layer 3323, and a second electron injection layer 3325 positioned on the second electron transport layer 3324. In such an example, the first electrode 110 may be the anode electrode, and the second electrode 120 may be the cathode electrode. The second stack 332 may not include some of the layers shown in FIG. 3 or may include an additional functional layer, such as a light emitting assist layer.

The second light emitting layer 3323 may emit light of the same color as, or a different color from, the light emitted by the first light emitting layer 3313. In the disclosure, that the light emitting layers emit light of the same color means that the light emitting layers emit not only light of colors with the same color coordinates but also light of colors similar to each other to be classified as pixels representing the same color in the technical field of the disclosure.

The second light emitting layer 3323 may include a second host compound and a second dopant.

The type of the second host compound is not particularly limited. The second host compound may be the same as, or different from, the first host compound 33131.

The type of the second dopant is not particularly limited. The second dopant may be the same as, or different from, the first dopant 33132.

In embodiments of the disclosure, the second light emitting layer 3323 may emit light of the same color as the light emitted by the first light emitting layer 3313. In the above-described embodiments, the first light emitting layer 3323 may include the compound represented by chemical formula 2 described above.

In embodiments in which the first light emitting layer 3313 and the second light emitting layer 3323 emit light of the same color, the second host compound may be a compound represented by chemical formula 1 described above. The second host compound may further include another compound different from the compound represented by chemical formula 1 described above. For example, the second host compound may include a compound represented by chemical formula 1 and a biscarbazole-based compound.

In embodiments in which the first light emitting layer 3313 and the second light emitting layer 3323 emit light of the same color, the type of the second dopant is not particularly limited and may be the same as the first dopant 33132. For example, the second dopant may be a green phosphorescent dopant. For example, the second dopant may be a metal complex, such as of iridium.

The charge generation layer 333 may be formed between the plurality of light emitting layers to smoothly distribute charges, thereby increasing the current efficiency of the light emitting layer. Accordingly, the charge generation layer 333 is positioned between the first stack 331 including the first light emitting layer 3313 and the second stack 332 including the second light emitting layer 3323.

The charge generation layer 333 may include a p-type charge generation layer and an n-type charge generation layer to smoothly distribute charges. When the first electrode 110 is the anode electrode, and the second electrode 120 is the cathode electrode, the p-type charge generation layer may be positioned on the side of the cathode electrode, and the n-type charge generation layer may be positioned on the side of the anode electrode.

Although FIG. 3 illustrates a tandem-type organic light emitting element including two stacks, embodiments of the disclosure are not limited thereto but may include tandem-type organic light emitting elements including two or more stacks. When the organic light emitting element 300 includes an additional stack, an additional charge generation layer may be positioned between the additional stack and the first stack 331 or second stack 332 adjacent thereto.

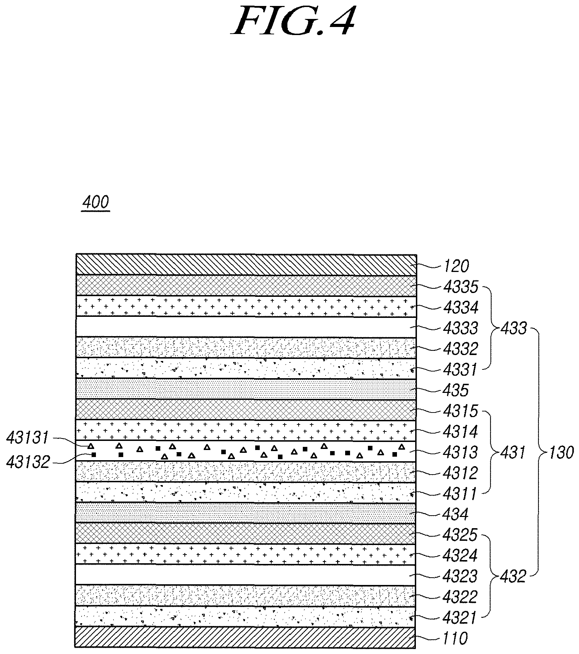

FIG. 4 is a view schematically illustrating an organic light emitting element according to embodiments of the disclosure.

Referring to FIG. 4, the organic material layer 130 includes a first stack 431, a second stack 432, a third stack 433, a first charge generation layer 434 positioned between the first stack 431 and the second stack 432, and a second charge generation layer 435 positioned between the first stack 431 and the third stack 433. In the embodiments illustrated in FIG. 4, the first stack 431 is positioned between the second stack 432 and the third stack 433, but embodiments of the disclosure including three stacks are limited to this structure, and the positions of the first stack 431, the second stack 432, and the third stack 433 may be exchanged with each other.

The organic light emitting element 400 may be a tandem-type organic light emitting element including a plurality of stacks each including a light emitting layer. The plurality of light emitting layers may be formed of the same material or different materials.

The first stack 431 may include a first light emitting layer 4313. The first light emitting layer 4313 may include, e.g., a first host compound 43131 and a first dopant 43132.

The first stack 431 may further include at least one of a hole injection layer, a hole transport layer, an electron transport layer, and an electron injection layer.

For example, the first stack 431 may include a first hole injection layer 4311 positioned on the first electrode 110, a first hole transport layer 4312 positioned on the first hole injection layer 4311, a first light emitting layer 4313 positioned on the first hole transport layer 4312, a first electron transport layer 4314 positioned on the first light emitting layer 4313, and a first electron injection layer 4315 positioned on the first electron transport layer 4314. In such an example, the first electrode 110 may be the anode electrode, and the second electrode 120 may be the cathode electrode. The first stack 431 may not include some of the layers shown in FIG. 4 or may include an additional functional layer, such as a light emitting assist layer.

The first light emitting layer 4313 may include the compound represented by chemical formula 1 described above.

The first light emitting layer 4313 may include a first host compound 43131 and a first dopant 43132. The first host compound 43131 may be a compound represented by chemical formula 1 described above. The first host compound 43131 may further include another compound different from the compound represented by chemical formula 1 described above. For example, the first host compound 43131 may include a compound represented by chemical formula 1 and a biscarbazole-based compound.

The type of the first dopant 43132 is not particularly limited. For example, the first dopant 43132 may be a green phosphorescent dopant. For example, the first dopant 43132 may be a metal complex, such as of iridium.

The second stack 432 may include a second light emitting layer 4323. The second light emitting layer 4323 may include, e.g., a second host compound 43231 and a second dopant 43232.

The second stack 432 may further include at least one of a hole injection layer, a hole transport layer, an electron transport layer, and an electron injection layer.

For example, the second stack 432 may include a second hole injection layer 4321 positioned on the second electrode 110, a second hole transport layer 4322 positioned on the second hole injection layer 4321, a second light emitting layer 4323 positioned on the second hole transport layer 4322, a second electron transport layer 4324 positioned on the second light emitting layer 4323, and a second electron injection layer 4325 positioned on the second electron transport layer 4324. In such an example, the first electrode 110 may be the anode electrode, and the second electrode 120 may be the cathode electrode. The second stack 432 may not include some of the layers shown in FIG. 4 or may include an additional functional layer, such as a light emitting assist layer.

The second light emitting layer 4323 may emit light of the same color as or a different color from, the light emitted by the first light emitting layer 4313.

The second light emitting layer 4323 may include a second host compound and a second dopant.

The type of the second host compound is not particularly limited. The second host compound may be the same as, or different from, the first host compound 43131.

The type of the second dopant is not particularly limited. The second dopant may be the same as, or different from, the first dopant 43132.

In embodiments of the disclosure, the second light emitting layer 4323 may emit light of the same color as the light emitted by the first light emitting layer 4313. In the above-described embodiments, the first light emitting layer 4323 may include the compound represented by chemical formula 2 described above.

In embodiments in which the first light emitting layer 4313 and the second light emitting layer 4323 emit light of the same color, the second host compound may be a compound represented by chemical formula 1 described above. The second host compound may further include another compound different from the compound represented by chemical formula 1 described above. For example, the second host compound may include a compound represented by chemical formula 1 and a biscarbazole-based compound.

In embodiments in which the first light emitting layer 4313 and the second light emitting layer 4323 emit light of the same color, the type of the second dopant is not particularly limited and may be the same as the first dopant 43132. For example, the second dopant may be a green phosphorescent dopant. For example, the second dopant may be a metal complex, such as of iridium.

The third stack 433 may include a third light emitting layer 4333. The third light emitting layer 4333 may include, e.g., a third host compound and a third dopant.

The third stack 432 may further include at least one of a hole injection layer, a hole transport layer, an electron transport layer, and an electron injection layer.

For example, the third stack 432 may include a third hole injection layer 4331 positioned on the third electrode 110, a third hole transport layer 4332 positioned on the third hole injection layer 4331, a third light emitting layer 4333 positioned on the third hole transport layer 4332, a third electron transport layer 4334 positioned on the third light emitting layer 4333, and a third electron injection layer 4335 positioned on the third electron transport layer 4334. In such an example, the first electrode 110 may be the anode electrode, and the second electrode 120 may be the cathode electrode. The third stack 433 may not include some of the layers shown in FIG. 4 or may include an additional functional layer, such as a light emitting assist layer.

The third light emitting layer 4333 may emit light of the same color as or a different color from, the light emitted by the first light emitting layer 4313.

The third light emitting layer 4333 may include a third host compound and a third dopant.

The type of the third host compound is not particularly limited. The third host compound may be the same as, or different from, the first host compound 43131.

The type of the third dopant is not particularly limited. The third dopant may be the same as, or different from, the first dopant 43132.

In embodiments of the disclosure, the third light emitting layer 4333 may emit light of the same color as the light emitted by the first light emitting layer 4313. In the above-described embodiments, the first light emitting layer 4333 may include the compound represented by chemical formula 3 described above.

In embodiments in which the first light emitting layer 4313 and the third light emitting layer 4333 emit light of the same color, the third host compound may be a compound represented by chemical formula 1 described above. The third host compound may further include another compound different from the compound represented by chemical formula 1 described above. For example, the third host compound may include a compound represented by chemical formula 1 and a biscarbazole-based compound.

In embodiments in which the first light emitting layer 4313 and the third light emitting layer 4333 emit light of the same color, the type of the second dopant is not particularly limited and may be the same as the first dopant 43132. For example, the second dopant may be a green phosphorescent dopant. For example, the second dopant may be a metal complex, such as of iridium.

The first host compound 43131, the second host compound, and the third host compound may be the same as or different from each other. One or more of the first host compound 43131, the second host compound, and the third host compound may be a compound represented by chemical formula 1 described above. Accordingly, one of the first host compound 43131, the second host compound, and the third host compound may include a compound represented by chemical formula 1 described above. Two of the first host compound 43131, the second host compound, and the third host compound may include a compound represented by chemical formula 1 described above. All of the first host compound 43131, the second host compound, and the third host compound may include a compound represented by chemical formula 1 described above. When there are two or more light emitting layers containing a host compound including the compound represented by chemical formula 1, the two or more light emitting layers may emit light of the same color.

The first dopant 33132, the second dopant, and the third dopant may be the same as or different from each other.

As the first stack 431, the second stack 432, and the third stack 433 are configured as described above, the holes and electrons transferred from the first electrode 110 and the second electrode 120 meet at the first light emitting layer 4313, the second light emitting layer 4323, and the third light emitting layer 4333, emitting light.

The first charge generation layer 434 and second charge generation layer 435 may be formed between the plurality of light emitting layers to smoothly distribute charges, thereby increasing the current efficiency of the light emitting layer. Accordingly, the first charge generation layer 434 may be positioned between the first stack 431 including the first light emitting layer 4313 and the second stack 432 including the second light emitting layer 4323, and the second charge generation layer 435 may be positioned between the second stack 432 including the second light emitting layer 433 and the third stack 433 including the third light emitting layer 4333.

The first charge generation layer 434 and second charge generation layer 435 may include a p-type charge generation layer and an n-type charge generation layer to smoothly distribute charges. When the first electrode 110 is the anode electrode, and the second electrode 120 is the cathode electrode, the p-type charge generation layer may be positioned on the side of the cathode electrode, and the n-type charge generation layer may be positioned on the side of the anode electrode.

The first charge generation layer 434 and the second charge generation layer 435 may be the same as or different from each other. The first charge generation layer 434 and the second charge generation layer 435 may be formed of the same material or different materials.

The compound represented by chemical formula 1 described above is described below.

The compound represented by chemical formula 1 described above may be represented by chemical formula 1 as follows.

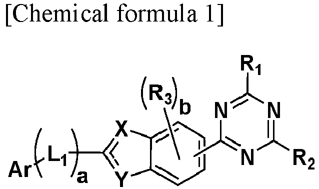

In chemical formula 1, either X or Y is N, and the other is S or O.

R₁ and R₂ each are independently selected from the group consisting of a C₆-C₆₀ aryl group; a fluorenyl group; and a C₂-C₆₀ heterocyclic group including at least one heteroatom of O, N, S, Si, and P.

When one or more of R₁ and R₂ are aryl groups, the aryl groups each may independently be a C₆-C₃₀ aryl group, a C₆-C₂₀ aryl group, or a C₆-C₁₂ aryl group.

When one or more of R₁ and R₂ are heterocyclic groups, the heterocyclic groups each may independently be a C₂-C₃₀ heterocyclic group, a C₂-C₂₀ heterocyclic group, or a C₂-C₁₂ heterocyclic group.

b is an integer from 0 to 3.

R₃ is, each independently, a C₁-C₂₀ alkyl group; or C₆-C₆₀ aryl group.

a is an integer from 0 to 2.

L1 is, each independently, selected from the group consisting of a single bond; fluorenylene group; and a C₆-C₆₀ arylene group.

When L1 is an arylene group, the arylene group may each independently be a C₆-C₃₀ arylene group, a C₆-C₂₀ arylene group, or a C₆-C₁₂ arylene group.

Ar is selected from the group consisting of hydrogen; halogen; a cyano group; a C₁-C₂₀ alkyl group; a fluorenyl group; C₆-C₆₀ aryl group; and a C₂-C₆₀ heterocyclic group including at least one heteroatom of O, N, S, Si and P.

The aryl group, the heterocyclic group, the arylene group, and the alkyl group each may be further substituted with one or more substituents selected from the group consisting of a halogen group; a C₁-C₂₀ alkyl group; a C₂-C₂₀ alkenyl group; a C₂-C₂₀ alkynyl group; a fluorenyl group; a C₆-C₂₀ aryl group; and a C₂-C₂₀ heterocyclic group.

One or more of the hydrogen atoms contained in the compound represented by chemical formula 1 may be substituted with deuterium or tritium.

By including the compound represented by chemical formula 1 described above, the organic light emitting elements 100 and 200 may have high efficiency or long lifespan.

When Ar is an aryl group or a heteroaryl group, Ar may be represented by any one of chemical formulas 2a to 2h below.

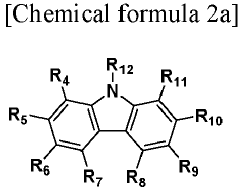

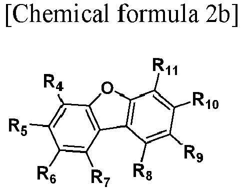

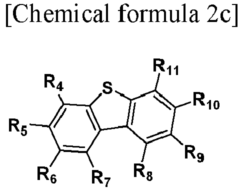

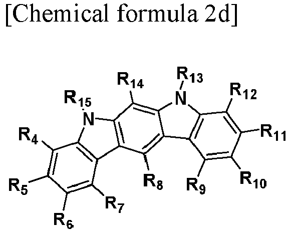

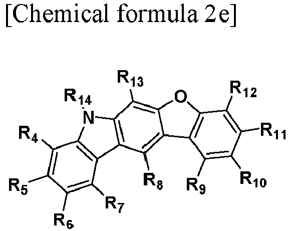

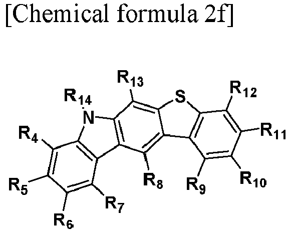

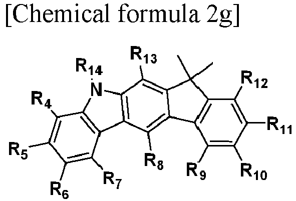

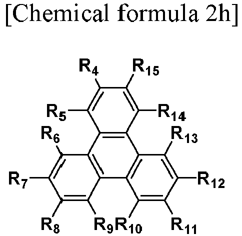

In chemical formula 2a, one of R₄ to R₁₂ is a single bond connected to L1 of chemical formula 1, and the rest, which are not single bonds, are each independently selected from the group consisting of a C₁-C₂₀ alkyl group; a fluorenyl group; a C₆-C₆₀ aryl group; and a C₂-C₆₀ heterocyclic group containing at least one heteroatom of O, N, S, Si and P.

In chemical formula 2b and chemical formula 2c, one of R₄ to R₁₁ is a single bond connected to L1 of chemical formula 1, and the rest, which are not single bonds, are each independently selected from the group consisting of a C₁-C₂₀ alkyl group; a fluorenyl group; a C₆-C₆₀ aryl group; and a C₂-C₆₀ heterocyclic group containing at least one heteroatom of O, N, S, Si and P.

In chemical formula 2d and chemical formula 2h, one of R₄ to R₁₅ is a single bond connected to L1 of chemical formula 1, and the rest, which are not single bonds, are each independently selected from the group consisting of a C₁-C₂₀ alkyl group; a fluorenyl group; a C₆-C₆₀ aryl group; and a C₂-C₆₀ heterocyclic group containing at least one heteroatom of O, N, S, Si and P.

In chemical formulas 2e, 2f, and 2g, one of R₄ to R₁₄ is a single bond connected to L1 of chemical formula 1, and the rest, which are not single bonds, are each independently selected from the group consisting of a C₁-C₂₀ alkyl group; a fluorenyl group; a C₆-C₆₀ aryl group; and a C₂-C₆₀ heterocyclic group containing at least one heteroatom of O, N, S, Si and P.

One or more of the hydrogen atoms of the aryl group or heteroaryl group represented by chemical formulas 2a to 2h may be substituted with deuterium or tritium.

The compound represented by chemical formula 1 may be represented by any one of chemical formulas 1a and 1b below.

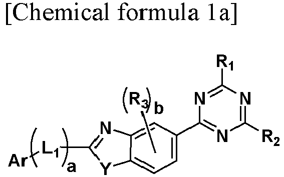

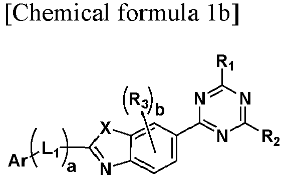

In chemical formula 1a and chemical formula 1b, X and Y are each S or O.

R₁, R₂, R₃, L1, Ar, a and b are the same as those described above in connection with chemical formula 1.

The compound represented by chemical formula 1 described above may be one or more of the above-described compounds. 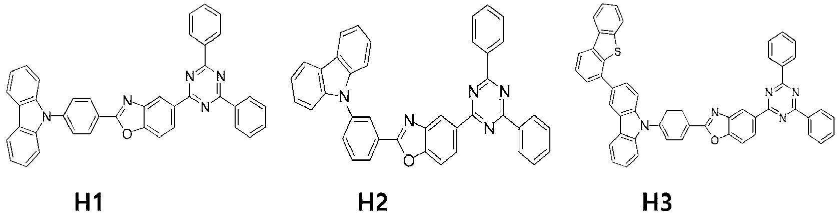 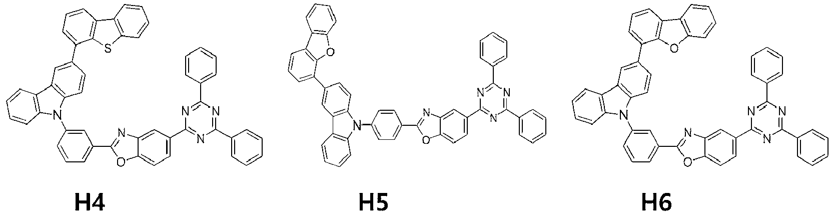 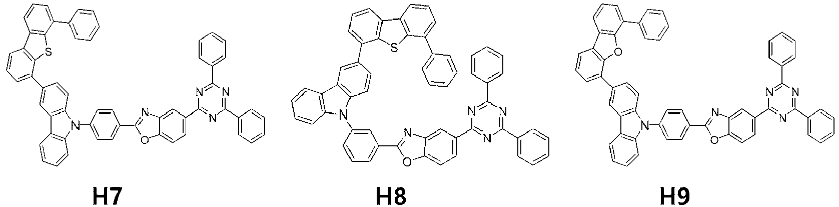 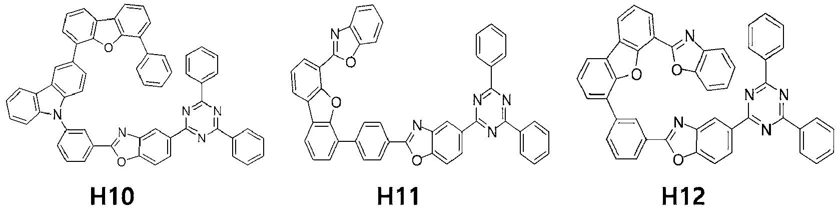 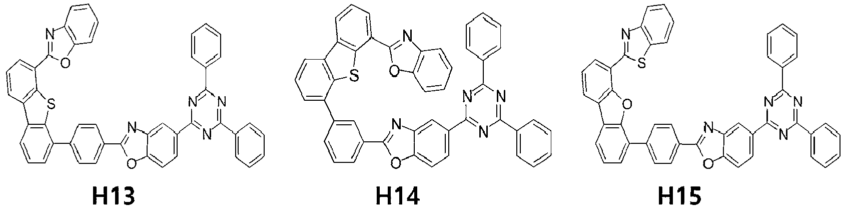 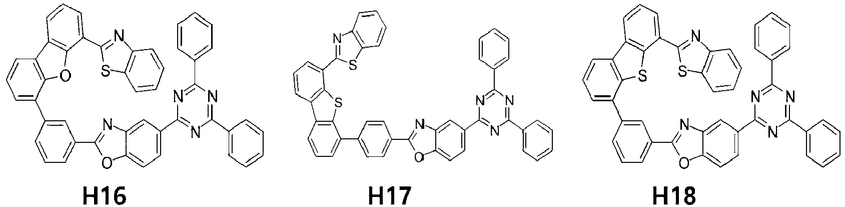 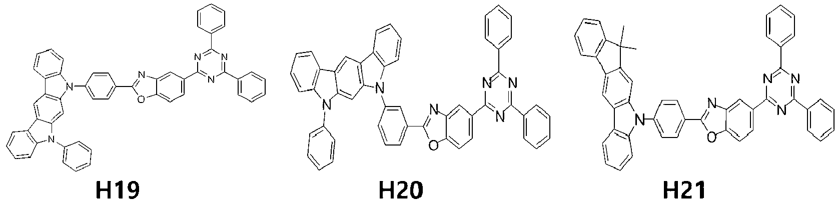 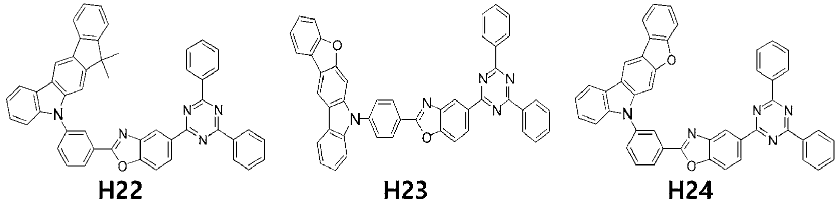 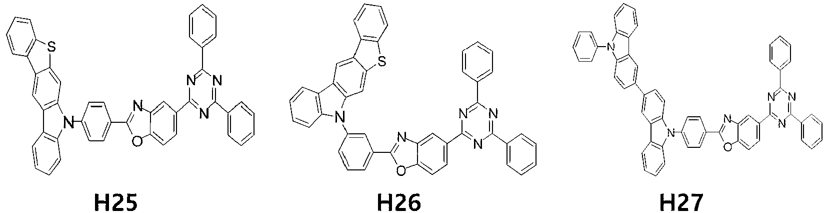 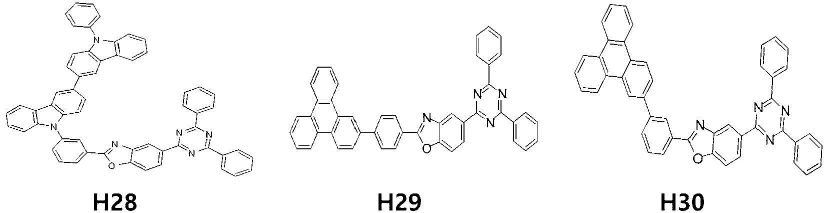 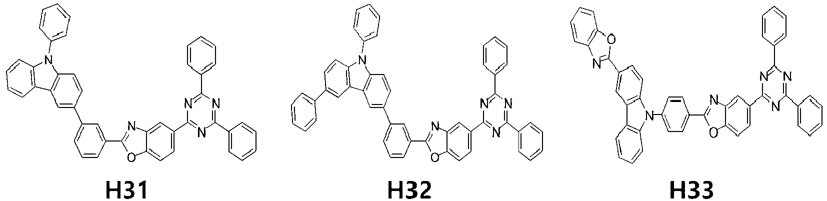 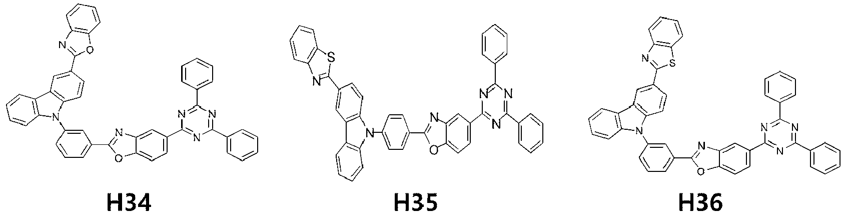 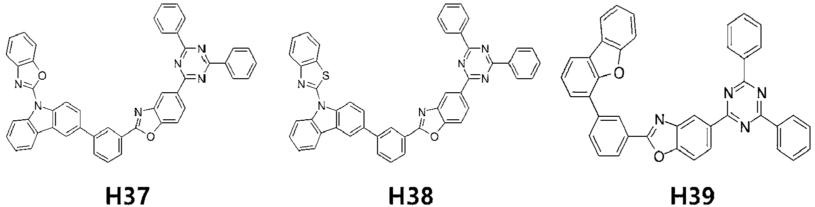 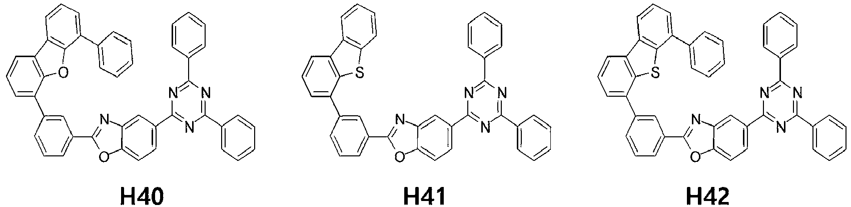 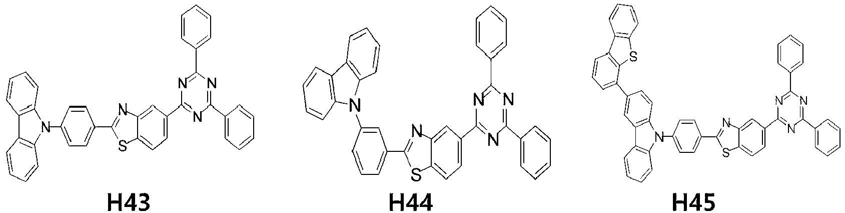 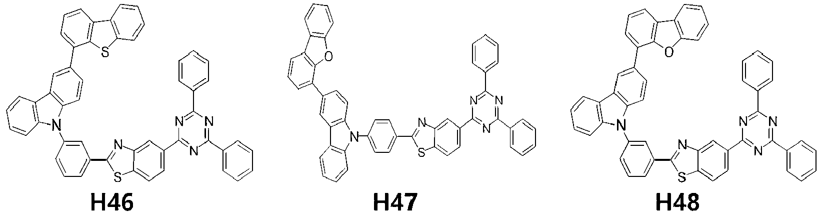 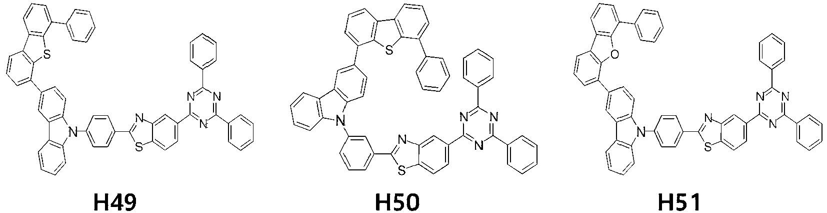 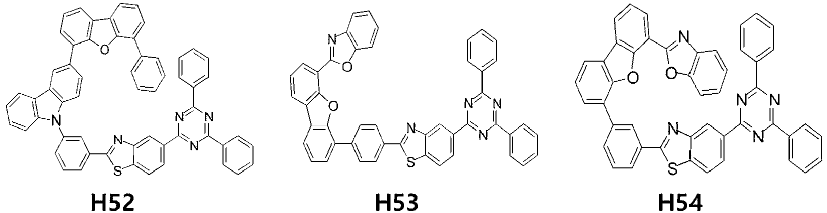 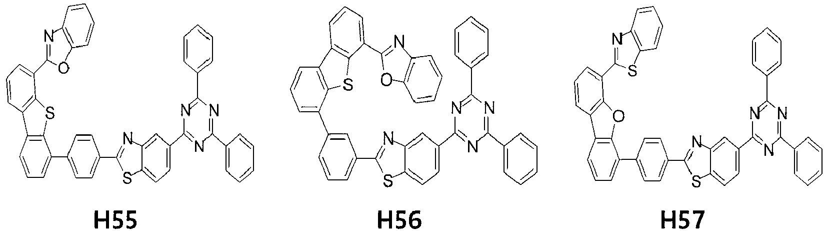 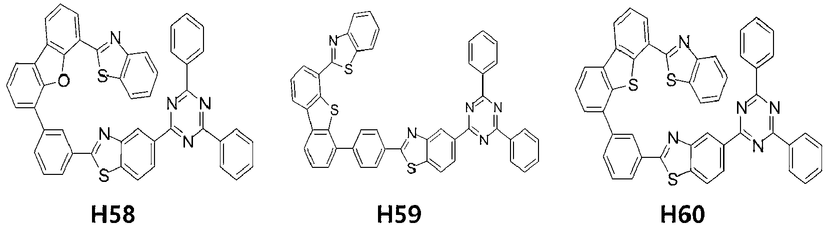 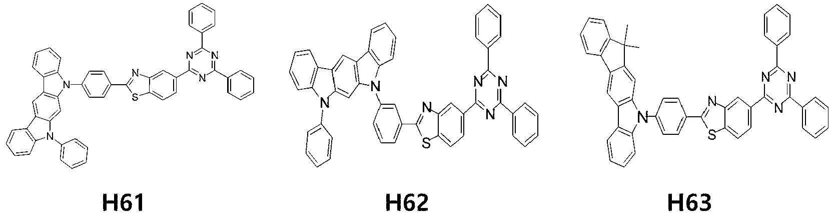 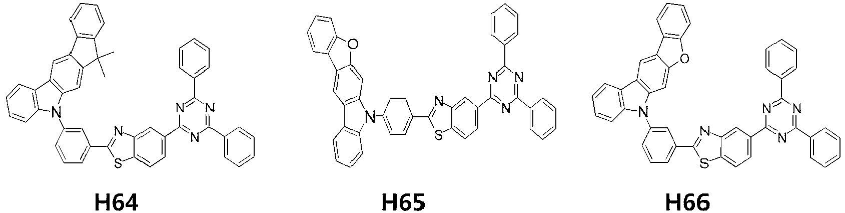 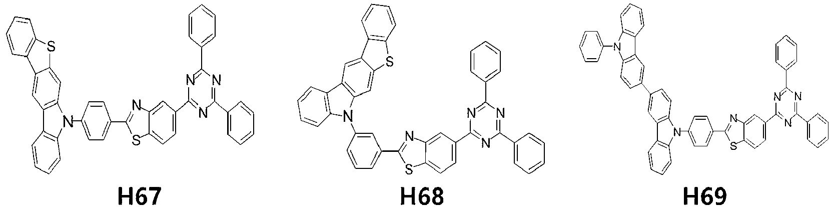 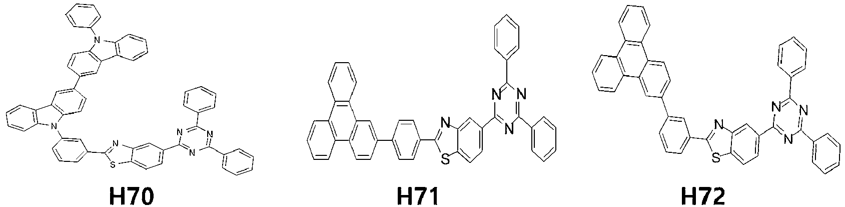 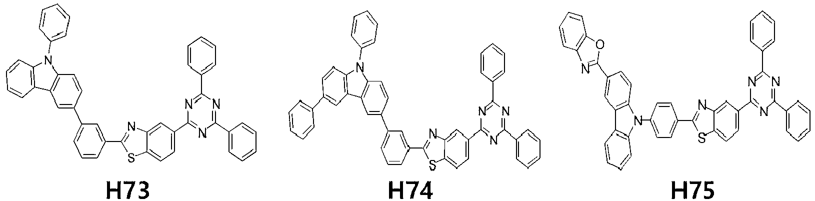 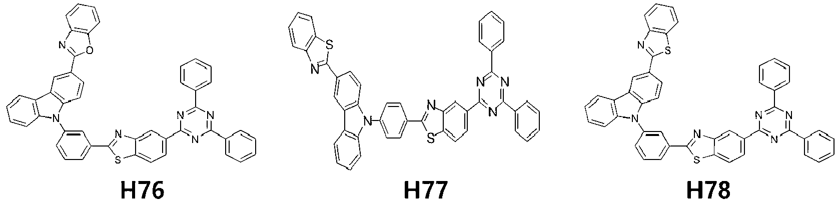 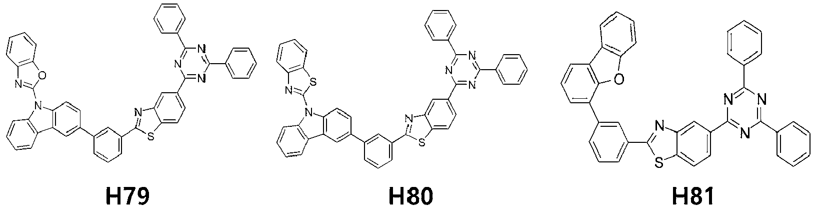 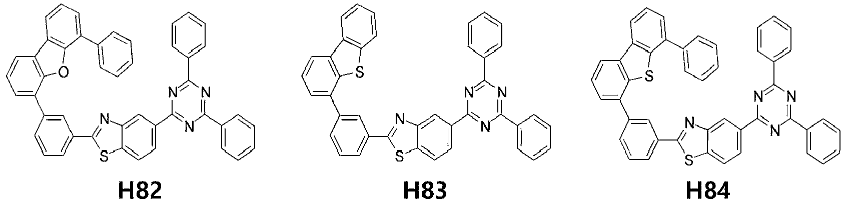 *

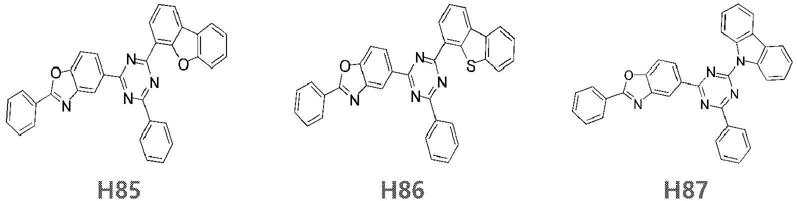

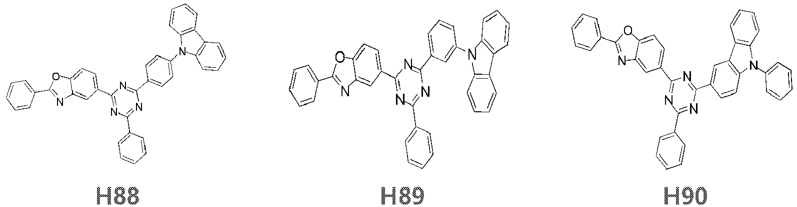

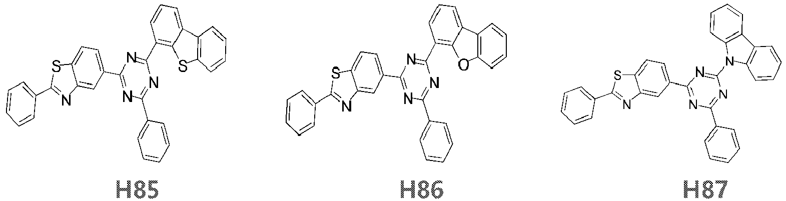

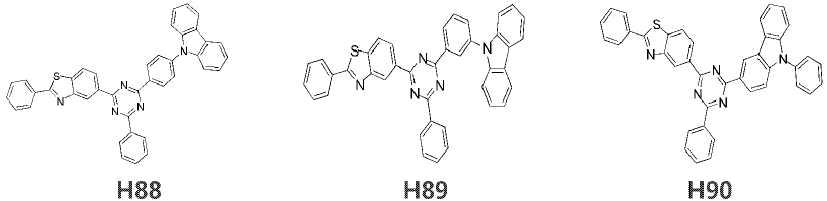

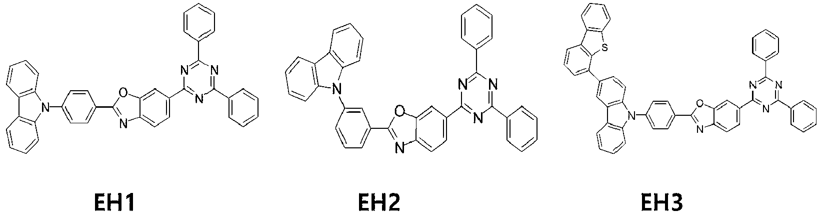

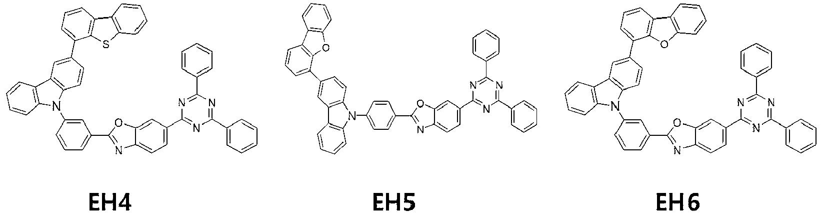

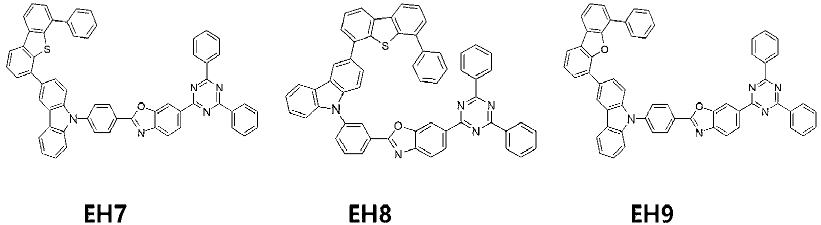

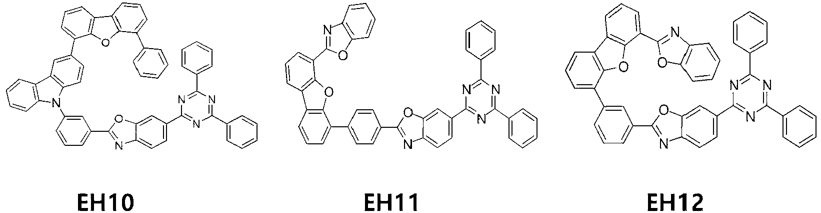

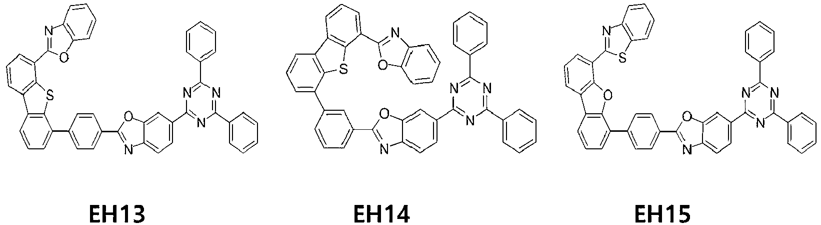

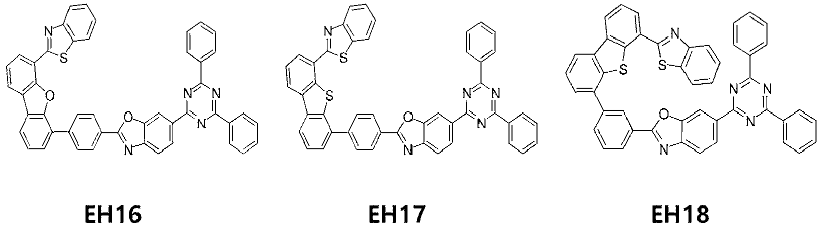

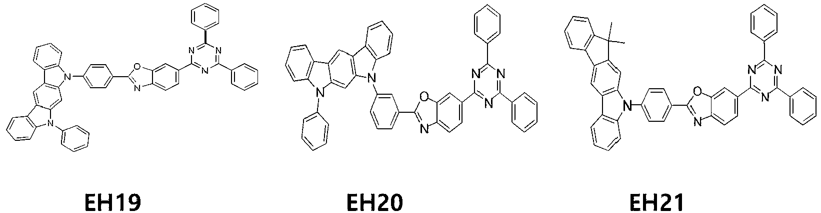

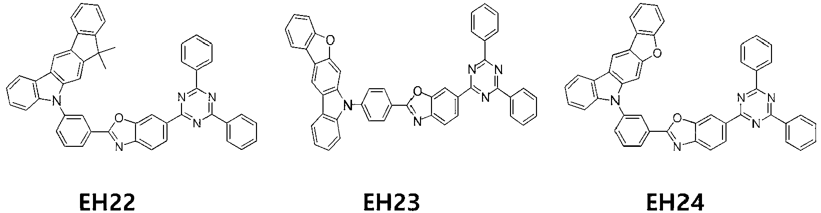

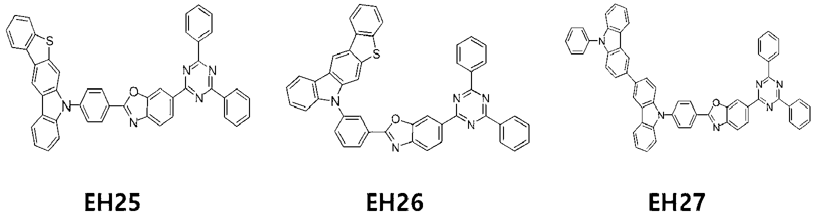

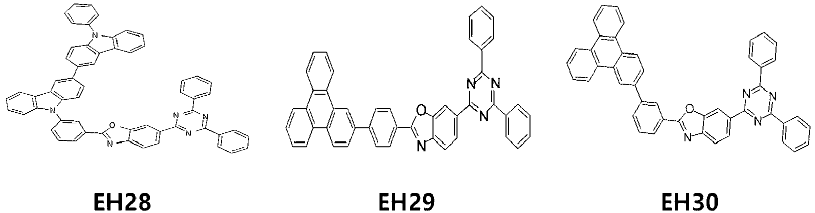

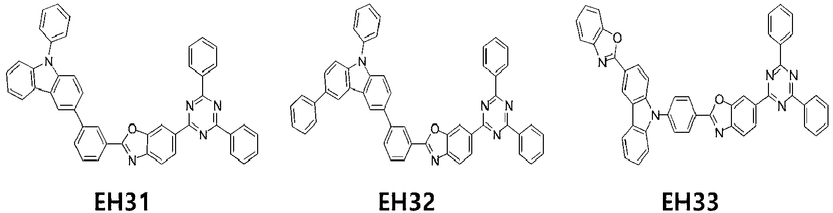

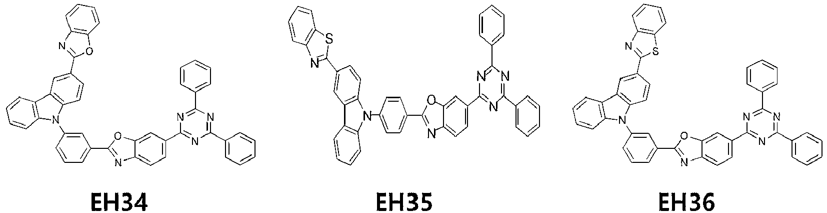

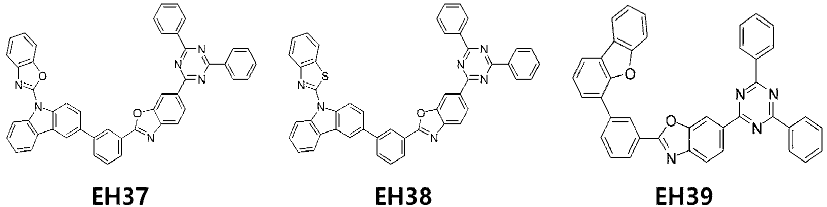

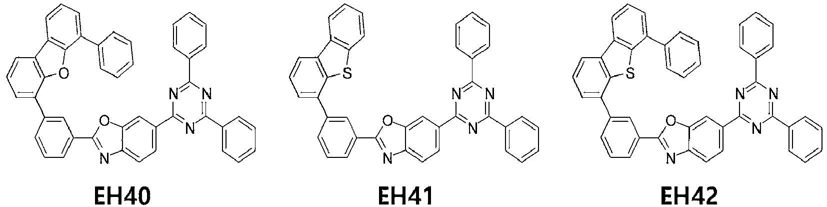

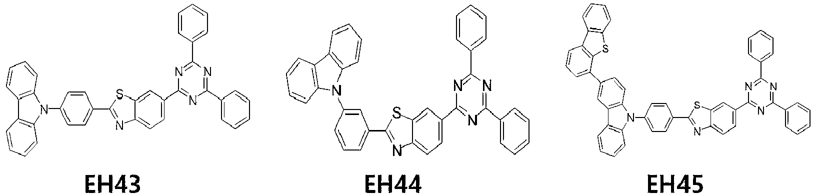

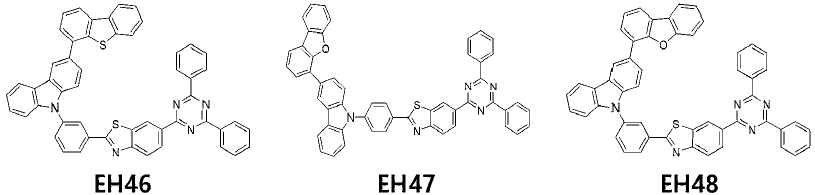

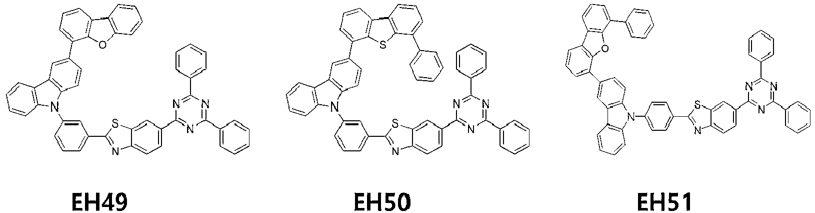

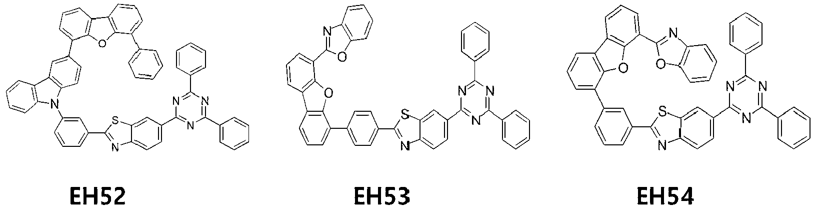

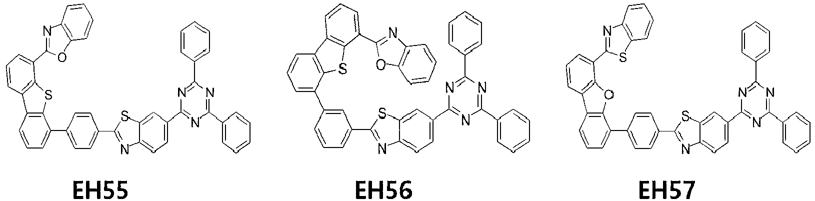

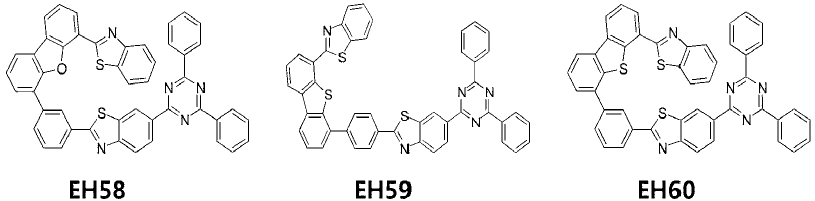

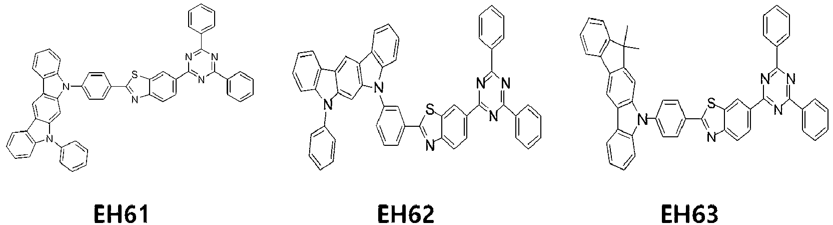

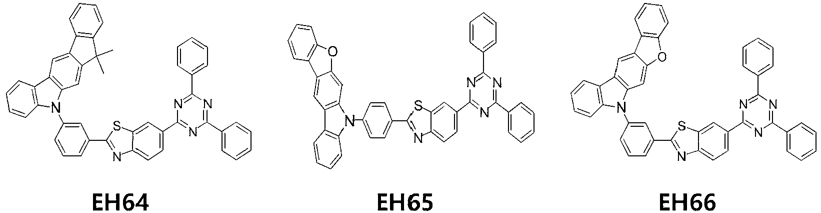

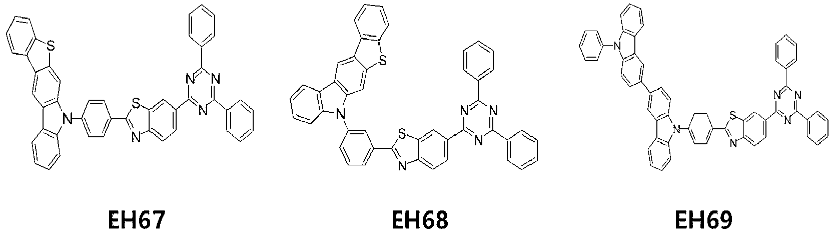

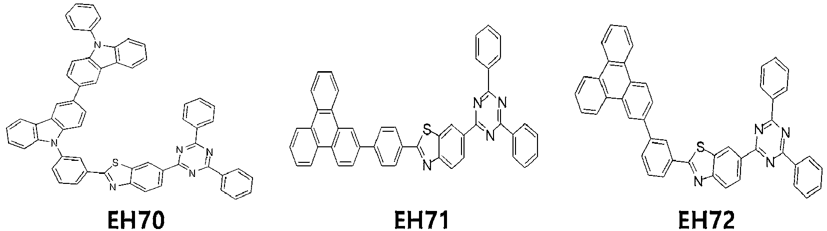

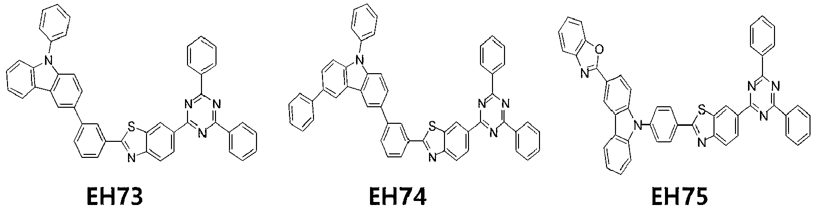

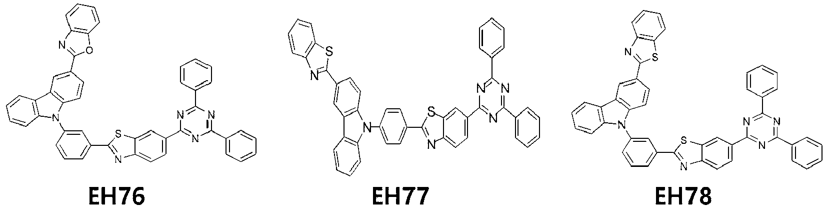

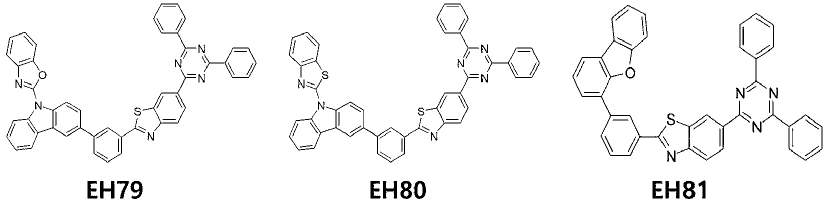

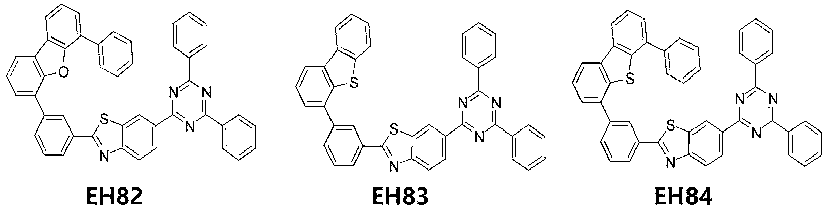

One or more of the hydrogen atoms included in H1 to H90 and EH1 to EH84 may be substituted with deuterium or tritium.

The above description has been presented to enable any person skilled in the art to make and use the technical idea of the disclosure, and has been provided in the context of a particular application and its requirements. Various modifications, additions and substitutions to the described embodiments will be readily apparent to those skilled in the art, and the general principles defined herein may be applied to other embodiments and applications without departing from the spirit and scope of the disclosure. The above description and the accompanying drawings provide an example of the technical idea of the disclosure for illustrative purposes only. That is, the disclosed embodiments are intended to illustrate the scope of the technical idea of the disclosure. Thus, the scope of the disclosure is not limited to the embodiments shown, but is to be accorded the widest scope consistent with the claims. The scope of protection of the disclosure should be construed based on the following claims, and all technical ideas within the scope of equivalents thereof should be construed as being included within the scope of the disclosure.

An example of manufacturing an organic light emitting element according to embodiments of the disclosure are described below in detail with reference to embodiments thereof, but embodiments of the disclosure are not limited to the following embodiments.

### Example of preparing the compound

The compound represented by chemical formula 1 may be prepared by preparing the final compound according to synthesis methods 1 to 4 below.

### Synthesis method 1

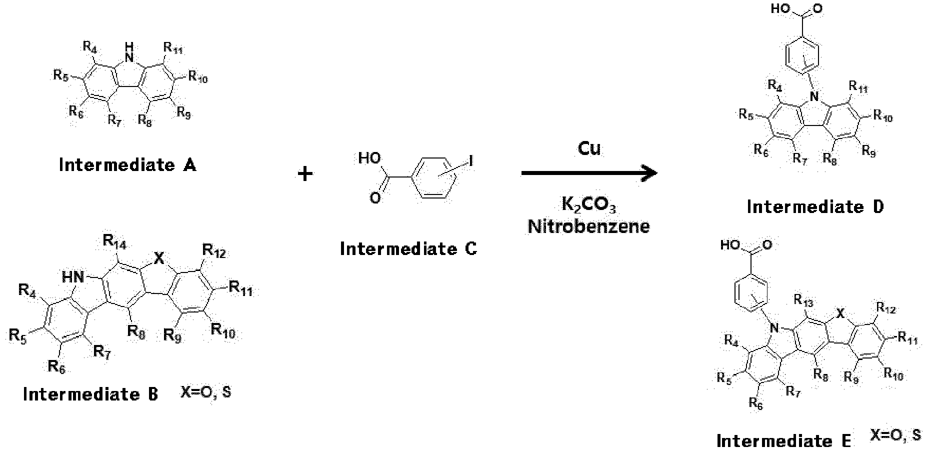

An intermediate A (or B, 1.0eq), an intermediate C (1.2eq), Cu (0.2eq), potassium carbonate (K2CO3, 1.5eq), and nitrobenzene are put in a round-bottom flask and are stirred under reflux for 24 hours. After the reaction is finished, the reaction solution is cooled and extracted with EA/H2O, and the organic layer is dried with MgSO4 to remove excess moisture, and is then concentrated under reduced pressure, obtaining a crude material. The obtained crude material was subjected to column separation, obtaining an intermediate D in a yield of 65%.

### Synthesis method 2

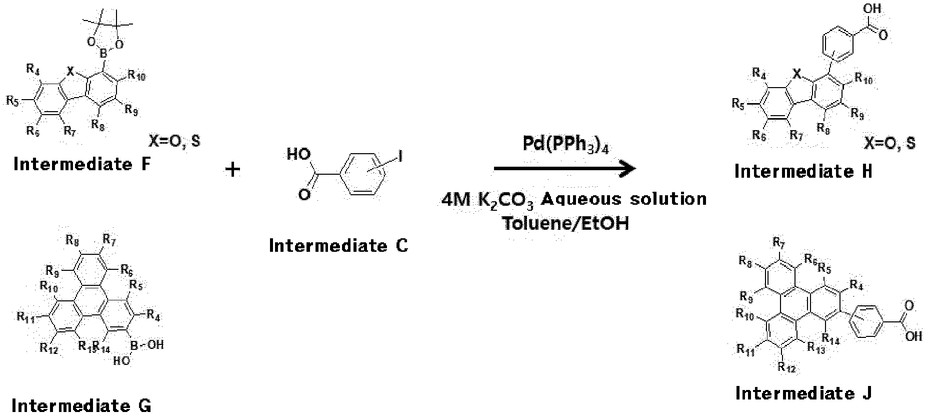

An intermediate F(or G,1.2eq), an intermediate C(1eq), tetrakistriphenylphosphine (Pd(PPh3)4, 0.02eq), 4M K2CO3 aqueous solution (2eq), toluene, and ethanol were put in a round-bottom flask and was stirred under reflux for 12 hours.

After the reaction is finished, the reaction solution is cooled and extracted with EA/H2O, and the organic layer is dried with MgSO4 to remove excess moisture, and is then concentrated under reduced pressure, obtaining a crude material. The obtained crude material was subjected to column separation, obtaining an intermediate H in a yield of 68%.

### Synthesis method 3

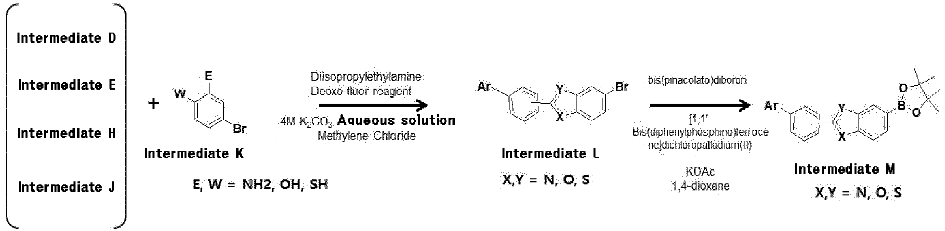

### Synthesis of intermediate L

An intermediate D (or E, H, or J, 1.0eq) and an intermediate K (2.2eq) are put in a round-bottom flask, and diisopropylethylamine (2.6eq), 4M K2CO3 aqueous solution (2eq), and methyl chloride are added, and are stirred while reducing the temperature to 0°C. A dioxo-fluor reagent, 50% in THF (2.2eq), diluted with 20ml of methyl chloride, is slowly added dropwise to the solution. After the dropwise addition is finished, the solution is stirred at 0°C for 2 hours. After the reaction is finished by adding a saturated aqueous sodium bicarbonate solution to the reaction solution, the solution is heated to room temperature.

After the reaction solution is separated into layers to recover the organic layer, the organic layer was dried with MgSO4 and concentrated under reduced pressure. The concentrated crude material was separated by column to obtain a compound in a yield of 81%.

### Synthesis of intermediate M

An intermediate L(1eq), bis(pinacolato)diboron(1.5eq), [1,1'-Bis(diphenylphosphino)ferrocene]dichloropalladium(II) (0.02eq), KOAc(potassium acetate, 2eq), and 1,4-dioxane are put in a round-bottom flask, heated, refluxed, and stirred for 12 hours. After cooling the reaction solution to room temperature, the solution is filtered using celite, and the celite is washed with CHCl3 (chloroform).

The filtrate was concentrated under reduced pressure and recrystallized with ethyl acetate (EA) to obtain a compound in a yield of 72%.

### Synthesis method 4

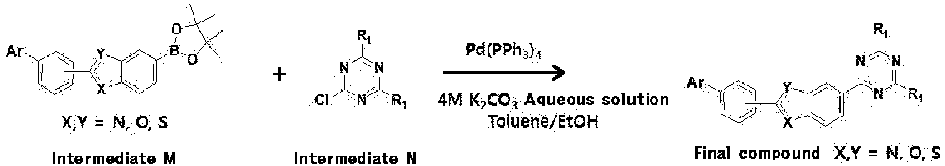

In the final compound, R₁, R₂, X, Y and Ar are the same as those defined in chemical formula 1 above.

An intermediate M(1.2eq), an intermediate N(1.0eq), tetrakis(triphenylphosphine) palladium(0)(0.02eq), toluene, EtOH, and 4M K2CO3 aqueous solution (2eq) were put in a round-bottom flask and were stirred under reflux for 12 hours. After completion of the reaction, the reaction solution is filtered to obtain a crude product.

The filtered crude material was column-separated with a solvent of CHCl3 (chloroform) to obtain a final material in a yield of 68%.

### Manufacturing evaluation of organic light emitting element

### Comparison example 1

An anode, a hole injection layer, a hole transport layer, a light emitting layer, an electron transport layer, an electron injection layer, and a cathode were formed on a substrate to manufacture an organic light emitting element having a mono structure as shown in Table 1 below. All the properties of the organic light emitting element manufactured in the disclosure were evaluated at room temperature using a constant current source and a photometer.

**[Table 1]**

| **Components** | **Materials** |
|---|---|
| anode | ITO(Indium tin oxide) |
| hole injection layer | HI1 |
| hole transport layer | HT1 |
| light emitting layer | EM1, EM2, EM3 |
| electron transport layer | ET1 |
| electron injection layer | LiF |
| cathode | Al |

The compounds used in the comparative examples are as follows.

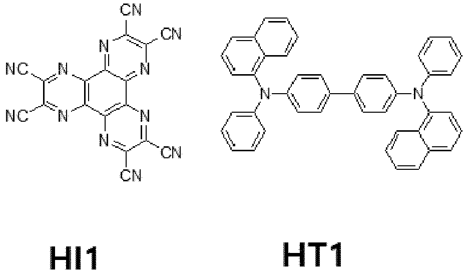

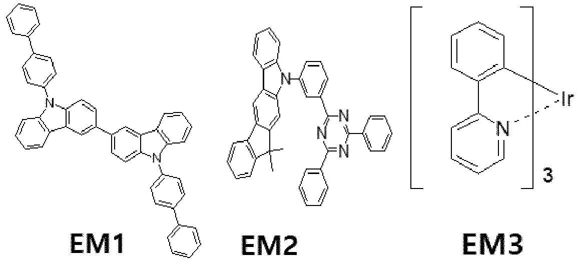

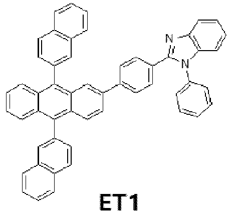

### Comparative examples 2 to 4 and embodiments 1 to 16

The organic light emitting element was manufactured in the same manner as in comparative example 1 except that the materials shown in Table 2 below were used instead of EM2 of the light emitting layer. The compounds used in comparative examples 2 to 4 are as follows.

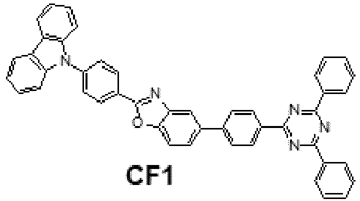

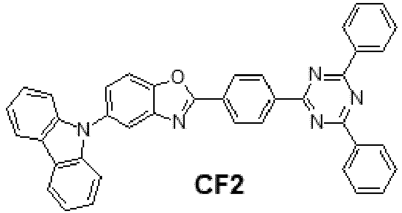

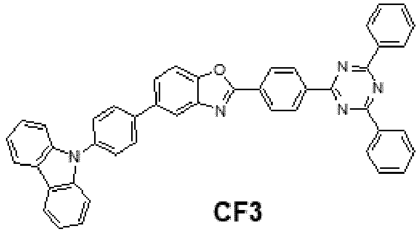

**[Table 2]**

| | **light emitting layer material** | **voltage difference** | **efficiency (embodiment/ comparative example 1, %)** | **lifespan (embodiment/ comparative example 1, %)** |
|---|---|---|---|---|
| **comparison example 1** | EM2 | - | - | - |
| **comparison example 2** | CF1 | 0.0 | 98% | 95% |
| **comparison example 3** | CF2 | 0.2 | 96% | 84% |
| **comparison example 4** | CF3 | 0.3 | 95% | 84% |
| **embodiment 1** | H1 | -0.12 | 106% | 105% |
| **embodiment 2** | H2 | -0.1 | 104% | 107% |
| **embodiment 3** | H4 | -0.1 | 105% | 103% |
| **embodiment 4** | H6 | -0.11 | 107% | 105% |
| **embodiment 5** | H11 | -0.05 | 108% | 104% |
| **embodiment 6** | H15 | -0.08 | 109% | 104% |
| **embodiment 7** | H22 | -0.15 | 103% | 109% |
| **embodiment 8** | H30 | -0.12 | 109% | 106% |
| **embodiment 9** | H31 | -0.1 | 105% | 105% |
| **embodiment 10** | H33 | -0.02 | 109% | 104% |
| **embodiment 11** | H37 | -0.04 | 106% | 104% |
| **embodiment 12** | H38 | -0.06 | 108% | 104% |
| **embodiment 13** | H43 | -0.15 | 105% | 104% |
| **embodiment 14** | H44 | -0.12 | 104% | 106% |
| **embodiment 15** | H48 | -0.17 | 101% | 103% |
| **embodiment 16** | H53 | -0.02 | 107% | 104% |
| **embodiment 17** | H57 | -0.03 | 107% | 104% |
| **embodiment 18** | H64 | -0.16 | 101% | 105% |
| **embodiment 19** | H72 | -0.14 | 107% | 106% |
| **embodiment 20** | H73 | -0.12 | 102% | 105% |
| **embodiment 21** | H75 | -0.04 | 107% | 103% |
| **embodiment 22** | H79 | -0.08 | 105% | 103% |
| **embodiment 23** | H80 | -0.07 | 107% | 102% |
| **embodiment 24** | H85 | -0.15 | 112% | 106% |
| **embodiment 25** | H89 | -0.20 | 110% | 105% |
| **embodiment 26** | EH1 | -0.11 | 105% | 107% |
| **embodiment 27** | EH2 | -0.08 | 104% | 112% |
| **embodiment 28** | EH4 | -0.10 | 104% | 104% |
| **embodiment 29** | EH6 | -0.10 | 106% | 108% |
| **embodiment 30** | EH11 | -0.05 | 108% | 106% |
| **embodiment 31** | EH15 | -0.06 | 108% | 109% |
| **embodiment 32** | EH22 | -0.15 | 102% | 110% |
| **embodiment 33** | EH30 | -0.10 | 108% | 105% |
| **embodiment 34** | EH31 | -0.09 | 103% | 105% |
| **embodiment 35** | EH33 | 0.0 | 107% | 102% |
| **embodiment 36** | EH37 | -0.02 | 102% | 100% |
| **embodiment 37** | EH38 | -0.05 | 107% | 100% |
| **embodiment 38** | EH43 | -0.14 | 103% | 107% |
| **embodiment 39** | EH44 | -0.11 | 103% | 108% |
| **embodiment 40** | EH48 | -0.10 | 106% | 105% |
| **embodiment 41** | EH53 | -0.04 | 107% | 106% |
| **embodiment 42** | EH57 | -0.06 | 107% | 103% |
| **embodiment 43** | EH64 | -0.12 | 102% | 109% |
| **embodiment 44** | EH72 | -0.07 | 107% | 106% |
| **embodiment 45** | EH73 | -0.07 | 104% | 103% |
| **embodiment 46** | EH75 | -0.01 | 106% | 101% |
| **embodiment 47** | EH79 | 0.0 | 102% | 100% |
| **embodiment 48** | EH80 | -0.03 | 107% | 100% |
| **embodiment 49** | EH85 | -0.12 | 108% | 108% |
| **embodiment 50** | EH89 | -0.15 | 107% | 110% |

Referring to Table 2, it may be seen that the organic light emitting element according to embodiments of the disclosure has better efficiency or lifespan than the organic light emitting elements of the comparative examples.

In comparative example 1, EM2 was used as the light emitting layer host compound. EM2 is similar to the compounds according to embodiments in that it contains a triazine core. However, it may be seen that the embodiments using compounds including a core represented by chemical formula 1, rather than EM2 including only a triazine core, have better efficiency and lifespan than comparative example 1.

In comparative example 2, CF1 was used as the light emitting layer host compound. CF1 is different from the compound represented by chemical formula 1 in that a phenylene linker is positioned between triazine and benzoxazole. It may be seen that the embodiments using compounds represented by chemical formula 1, in which triazine and benzoxazole are directly bonded, have better efficiency and lifespan than comparative example 2.

Comparative example 3 used CF2 as the light emitting layer host compound, and comparative example 4 used CF3 as the light emitting layer host compound. CF2 and CF3 are different from compounds used in the embodiments represented by chemical formula 1 in that triazine is bonded to the five-membered ring portion of benzoxazole through a phenylene linker. It may be seen that the embodiments using compounds represented by chemical formula 1, in which triazine is directly bonded to the benzene ring portion of benzoxazole, have better efficiency and lifespan than comparative examples 3 and 4.

It will be apparent to those skilled in the art that various modifications and variations can be made in the organic light emitting element of the present disclosure without departing from the scope of the disclosure. Thus, it is intended that the present disclosure cover the modifications and variations of this disclosure provided they come within the scope of the appended claims.

## Claims

1. An organic light emitting element (100, 200, 300, 400), comprising:
a first electrode (110);
a second electrode (120); and
an organic material layer (130) positioned between the first electrode (110) and the second electrode (120), wherein
the organic material layer (130) includes a compound represented by chemical formula 1 below: 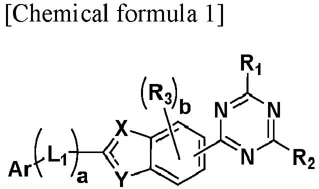
in chemical formula 1,
either X or Y is N, and the other is S or O, wherein
R₁ and R₂ are each independently selected from the group consisting of a C₆-C₆₀ aryl group; a fluorenyl group; and a C₂-C₆₀ heterocyclic group including at least one heteroatom of O, N, S, Si, and P,
b is an integer from 0 to 3,
R₃ is each independently a C₁-C₂₀ alkyl group; or C₆-C₆₀ aryl group,
a is an integer from 0 to 2,
L₁ is each independently selected from the group consisting of a single bond; a fluorenylene group; and a C₆-C₆₀ arylene group,
Ar is selected from the group consisting of hydrogen; halogen; a cyano group; a C₁-C₂₀ alkyl group; a fluorenyl group; a C₆-C₆₀ aryl group; and a C₂-C₆₀ heterocyclic group including at least one heteroatom of O, N, S, Si and P, and
the aryl group, the heterocyclic group, the arylene group, and the alkyl group each are further substituted with one or more substituents selected from the group consisting of a halogen group; a C₁-C₂₀ alkyl group; a C₂-C₂₀ alkenyl group; a C₂-C₂₀ alkynyl group; a fluorenyl group; a C₆-C₂₀ aryl group; and a C₂-C₂₀ heterocyclic group.

2. The organic light emitting element (100, 200, 300, 400) of claim 1, wherein the compound is represented by either chemical formula 1a or chemical formula 1b below: 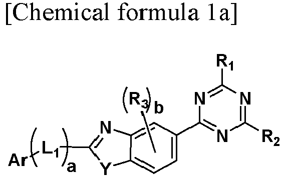 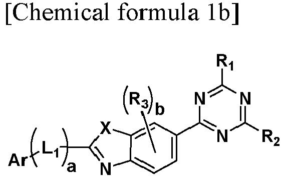
In chemical formula 1a and chemical formula 1b,
X and Y each are S or O, and
R₁, R₂, R₃, L₁, Ar, a and b are the same as those defined above in chemical formula 1.

3. The organic light emitting element (100, 200, 300, 400) of claim 1 or 2, wherein when Ar of chemical formula 1 is an aryl group or a heteroaryl group, Ar is represented by any one of chemical formulas 2a to 2h below: 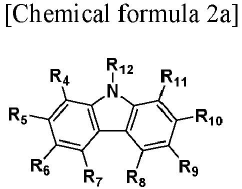 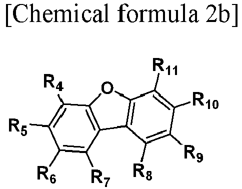 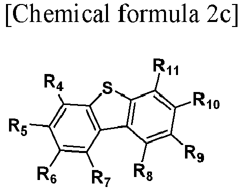 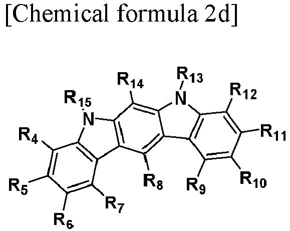 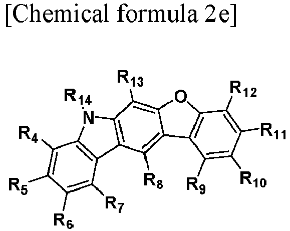 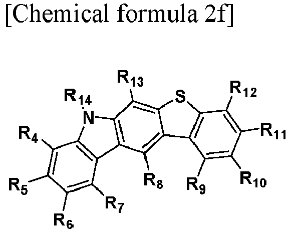 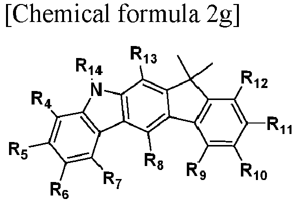 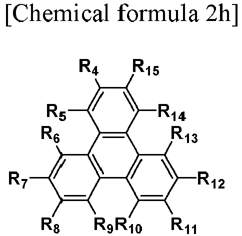
in chemical formula 2a,
one of R₄ to R₁₂ is a single bond connected to L₁ of chemical formula 1, and the rest, which are not single bonds, are each independently selected from the group consisting of a C₁-C₂₀ alkyl group; a fluorenyl group; a C₆-C₆₀ aryl group; and a C₂-C₆₀ heterocyclic group containing at least one heteroatom of O, N, S, Si, and P.
in chemical formula 2b and chemical formula 2c,
one of R₄ to R₁₁ is a single bond connected to L₁ of chemical formula 1, and the rest, which are not single bonds, are each independently selected from the group consisting of a C₁-C₂₀ alkyl group; a fluorenyl group; a C₆-C₆₀ aryl group; and a C₂-C₆₀ heterocyclic group containing at least one heteroatom of O, N, S, Si, and P,
in chemical formula 2d and chemical formula 2h,
one of R₄ to R₁₅ is a single bond connected to L₁ of chemical formula 1, and the rest, which are not single bonds, are each independently selected from the group consisting of a C₁-C₂₀ alkyl group; a fluorenyl group; a C₆-C₆₀ aryl group; and a C₂-C₆₀ heterocyclic group containing at least one heteroatom of O, N, S, Si, and P, and
in chemical formulas 2e, 2f, and 2g,
one of R₄ to R₁₄ is a single bond connected to L₁ of chemical formula 1, and the rest, which are not single bonds, are each independently selected from the group consisting of a C₁-C₂₀ alkyl group; a fluorenyl group; a C₆-C₆₀ aryl group; and a C₂-C₆₀ heterocyclic group containing at least one heteroatom of O, N, S, Si, and P.

4. The organic light emitting element (100, 200, 300, 400) of claim 1, wherein the compound represented by chemical formula 1 is one or more of compounds below:

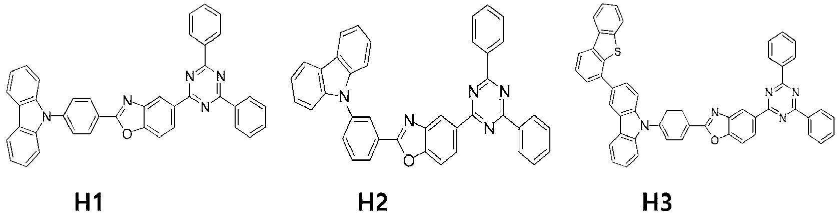

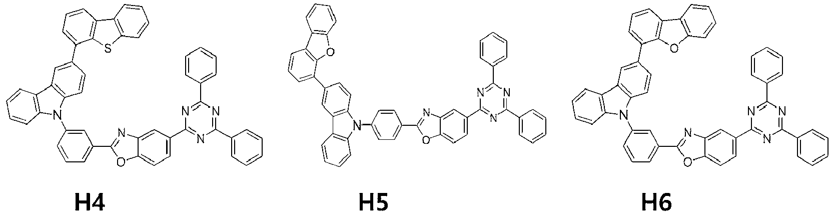

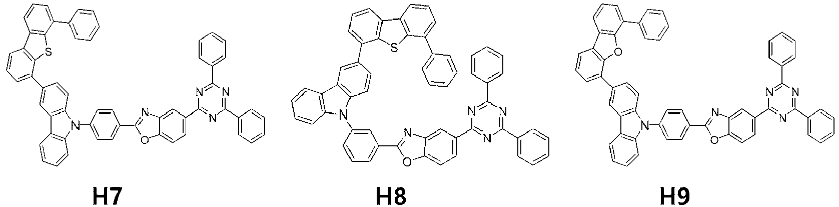

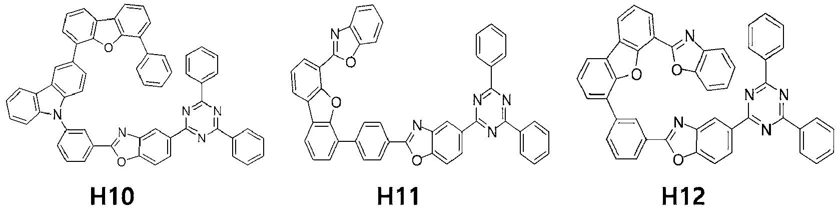

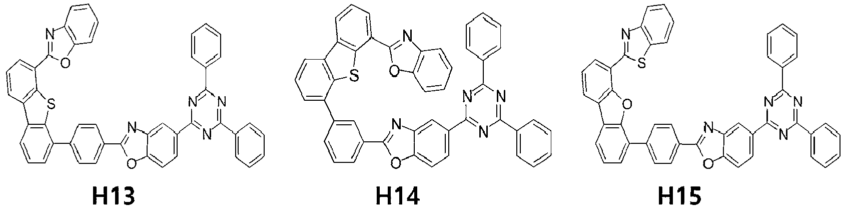

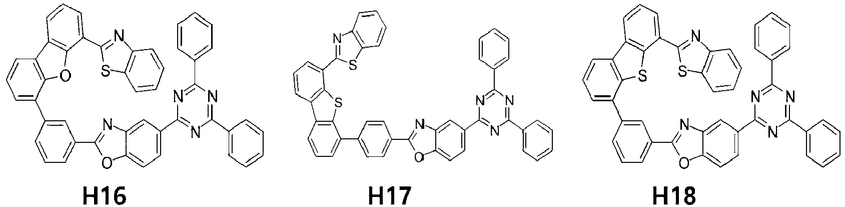

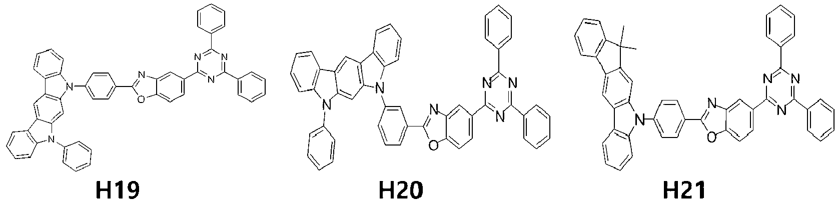

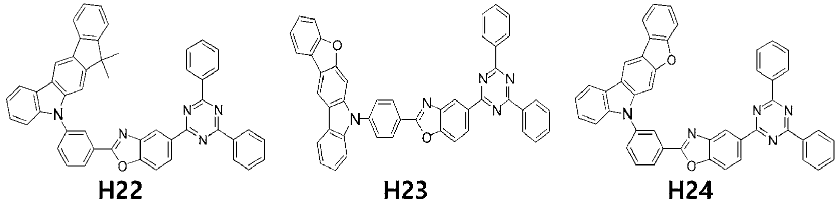

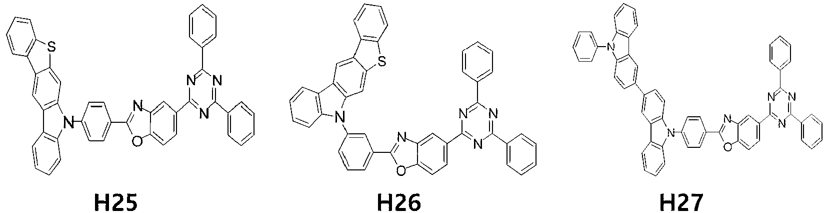

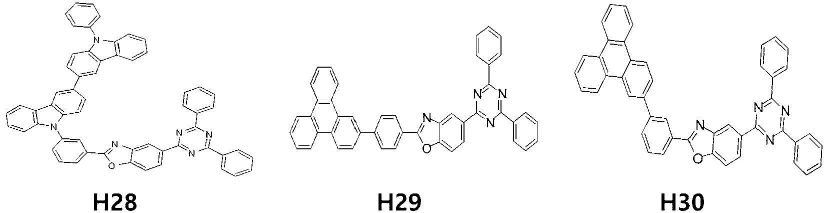

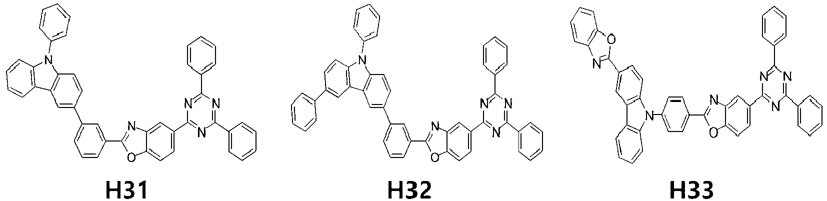

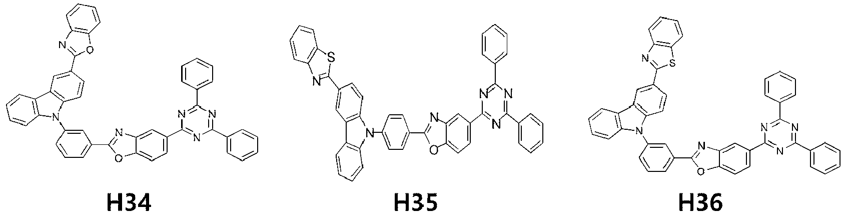

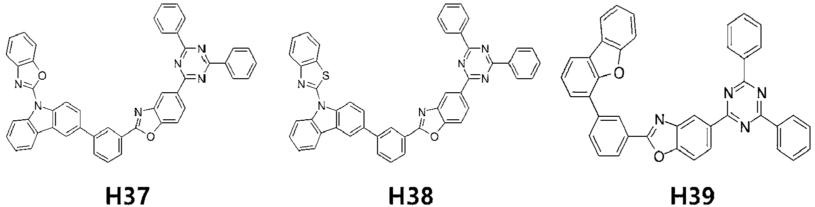

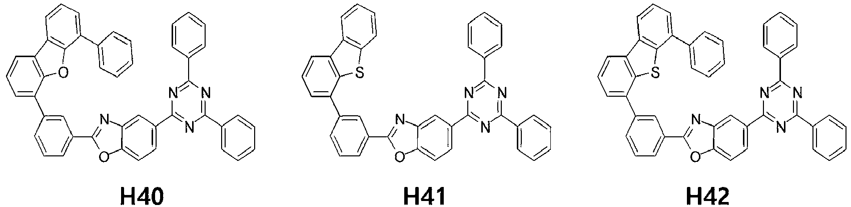

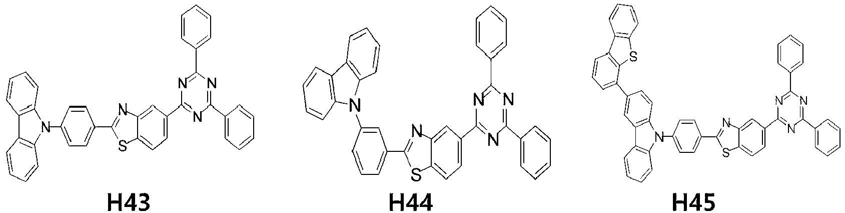

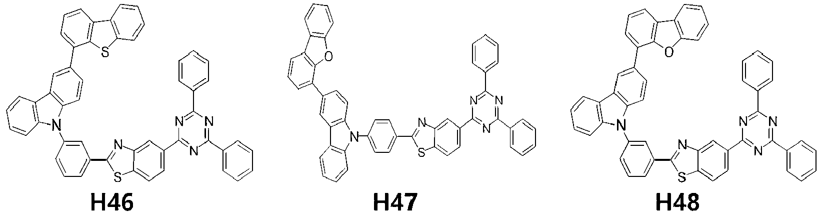

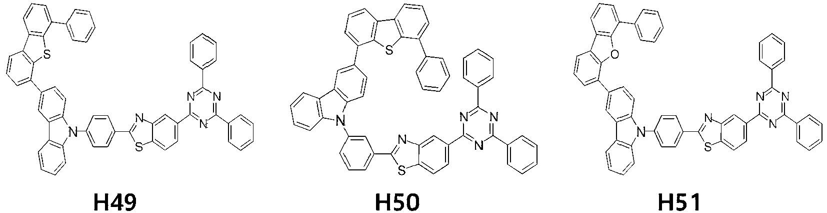

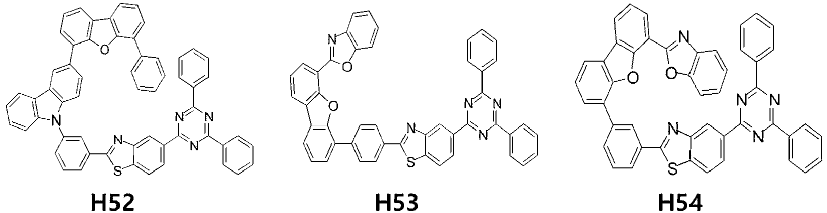

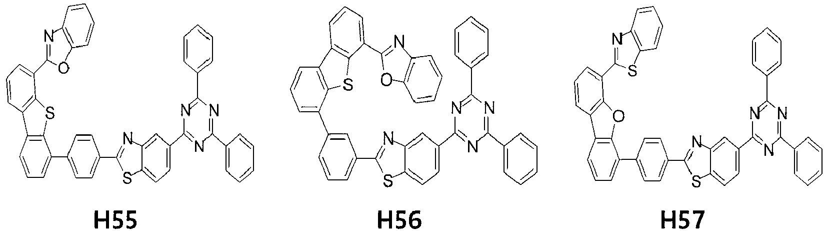

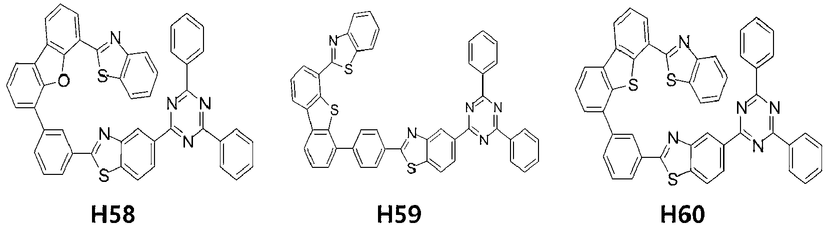

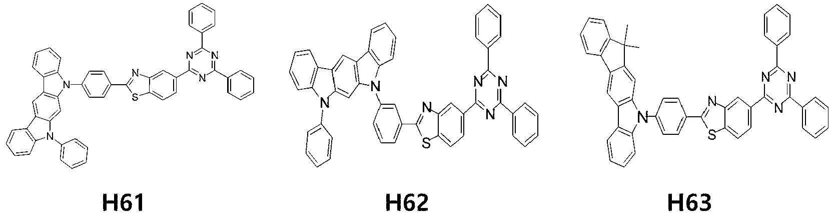

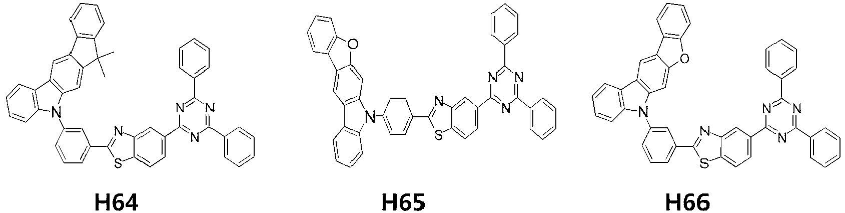

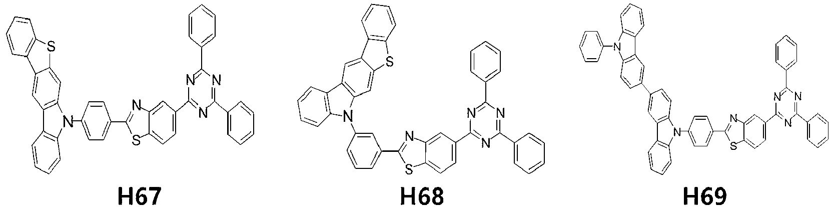

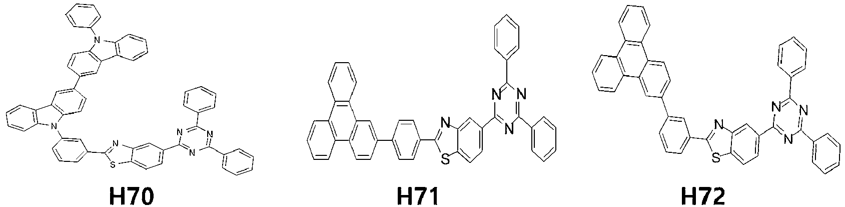

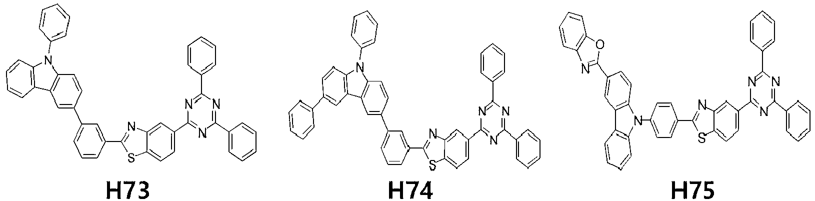

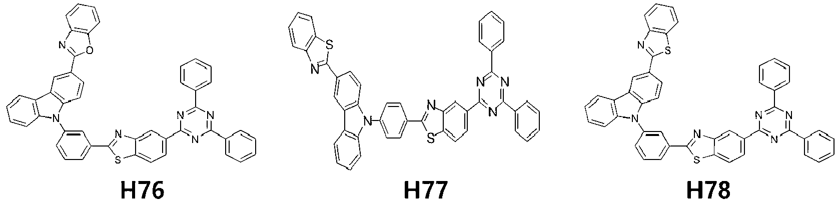

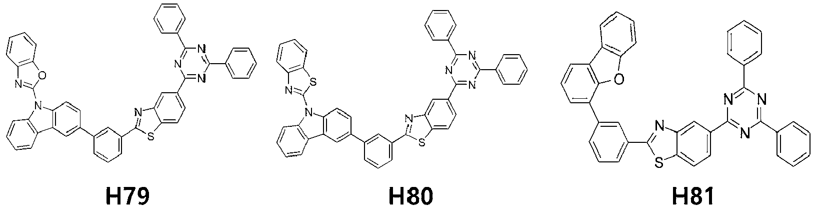

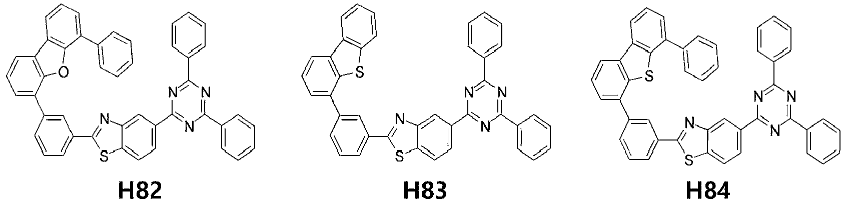

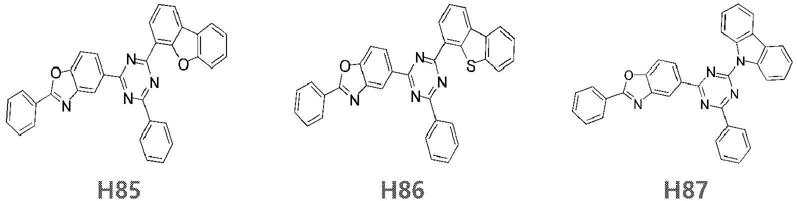

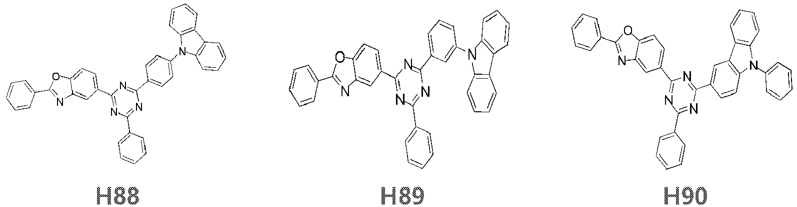

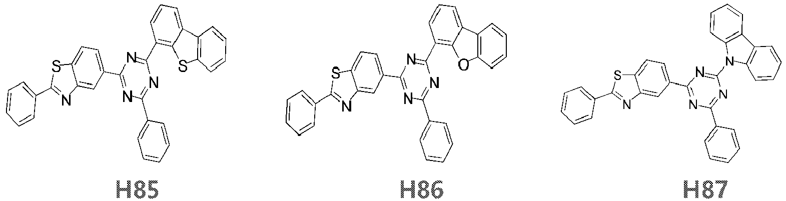

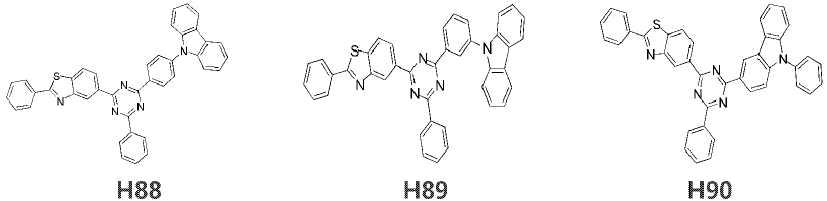

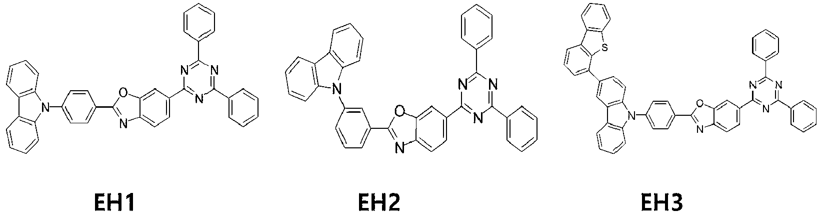

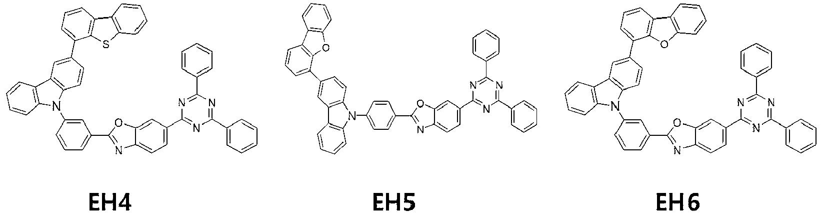

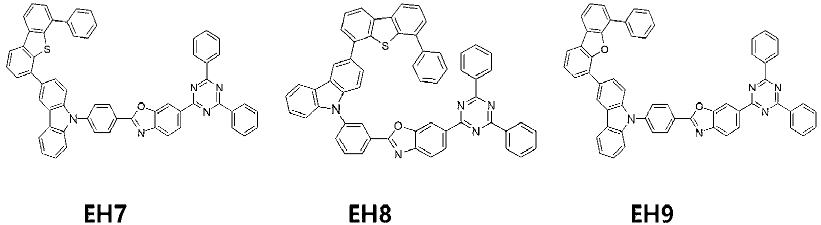

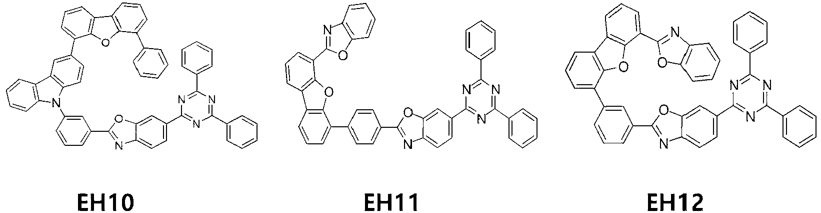

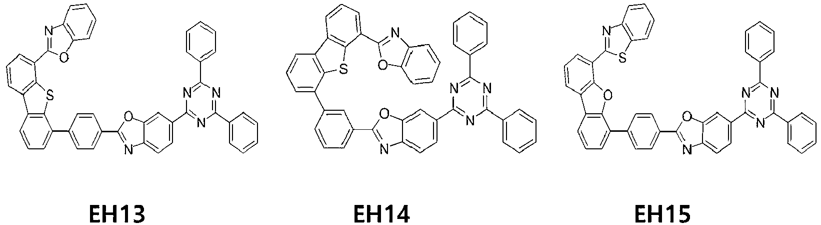

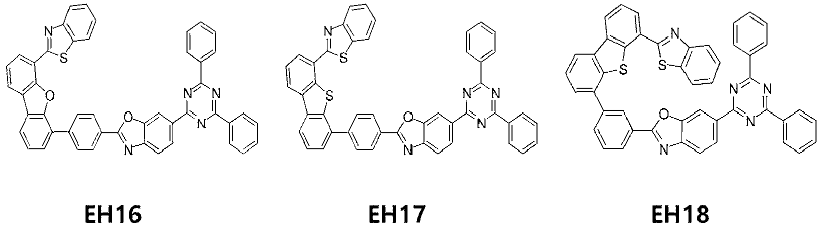

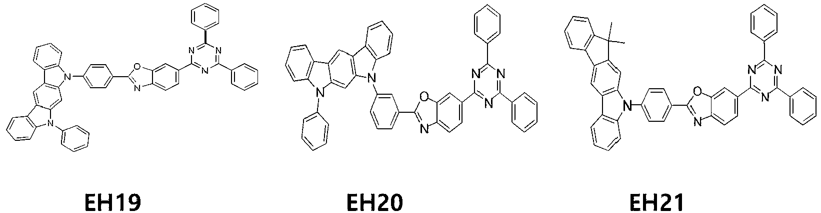

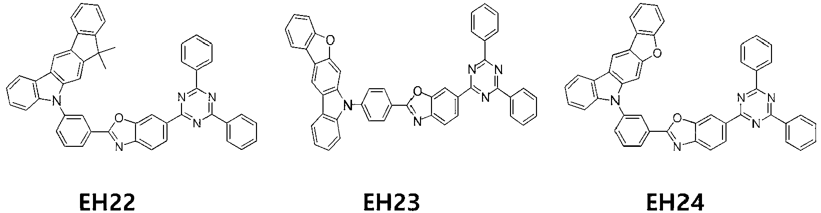

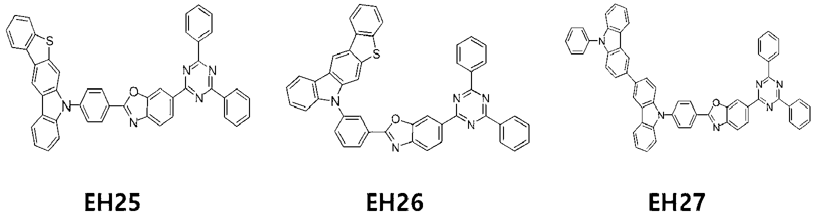

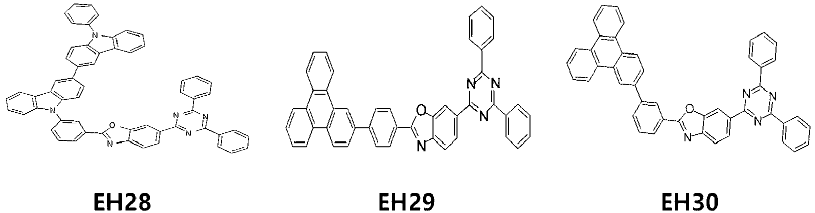

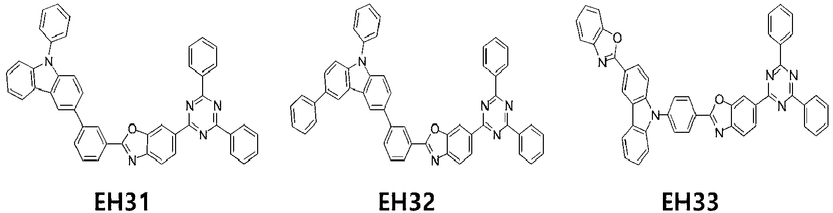

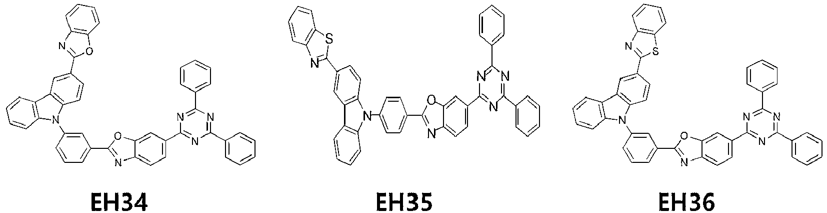

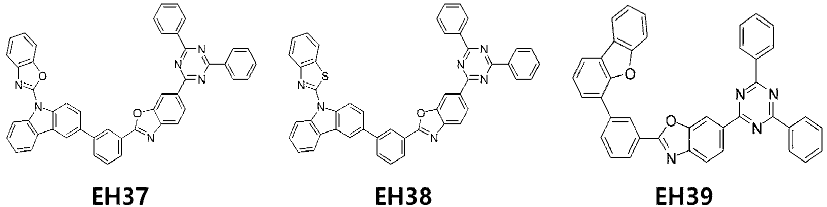

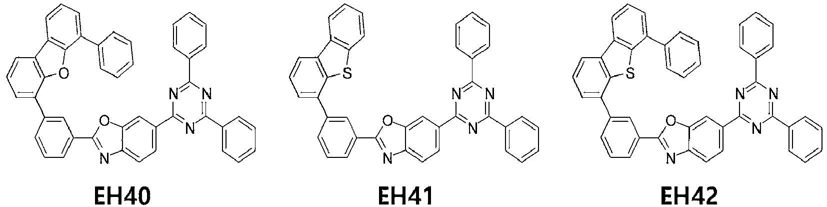

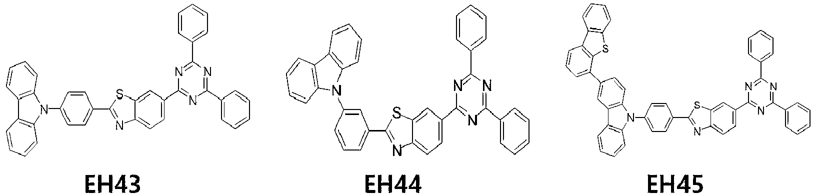

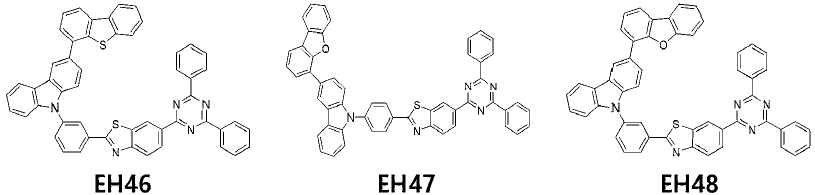

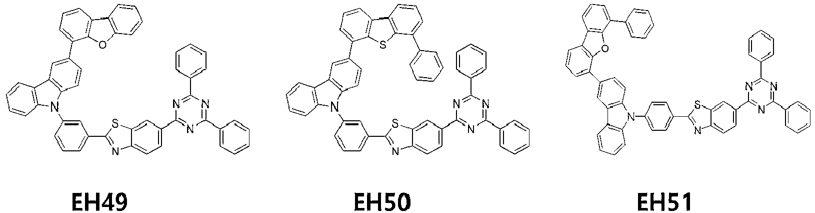

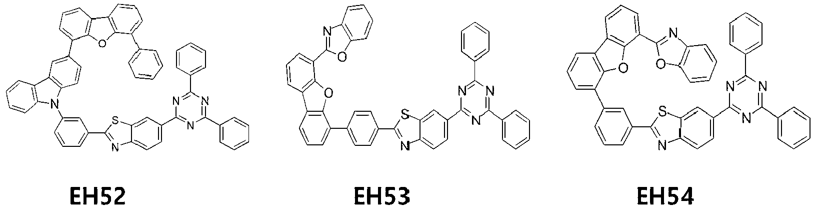

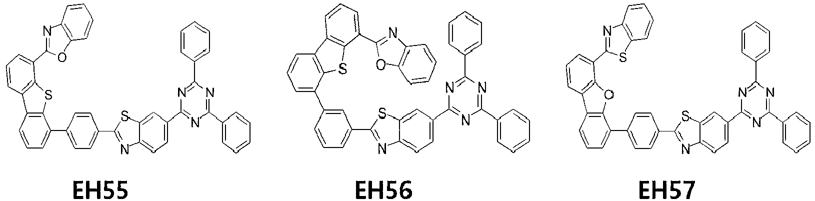

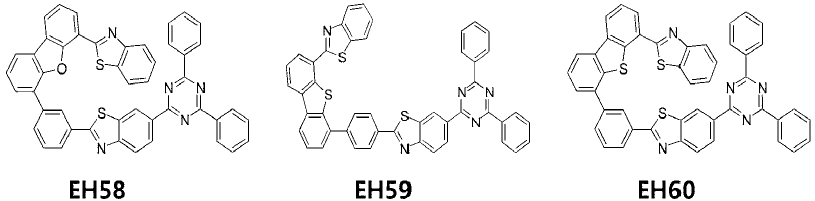

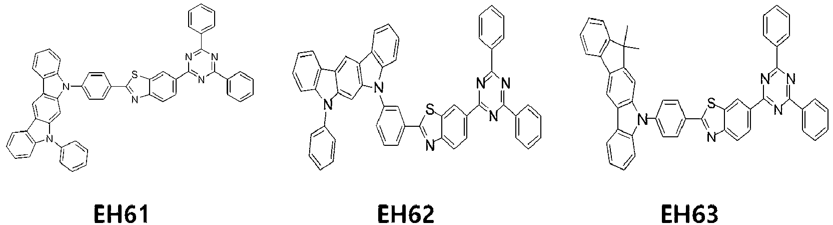

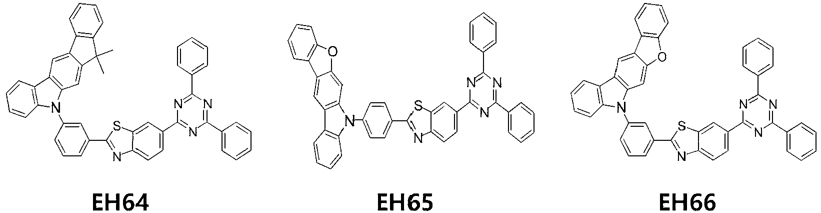

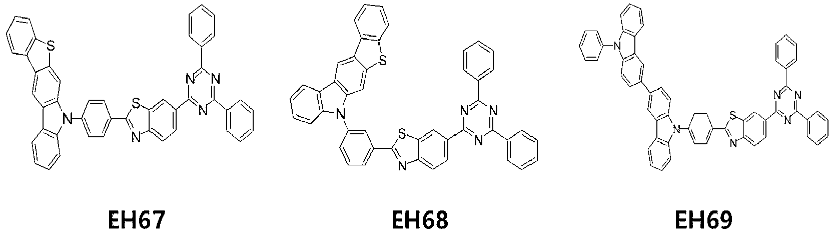

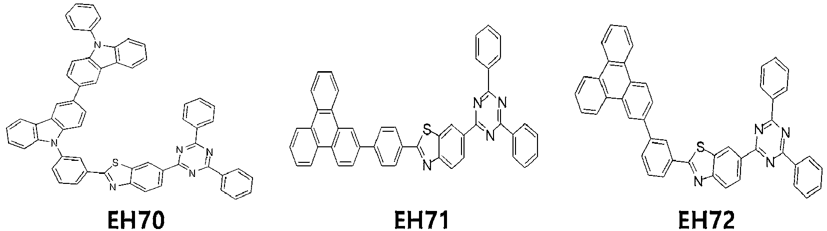

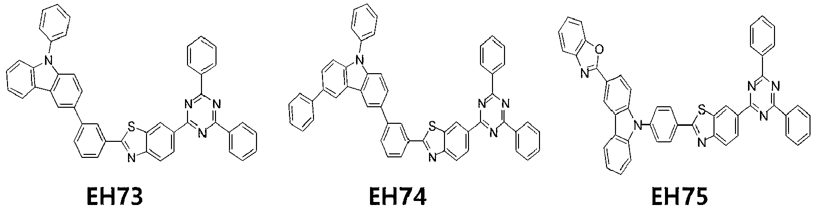

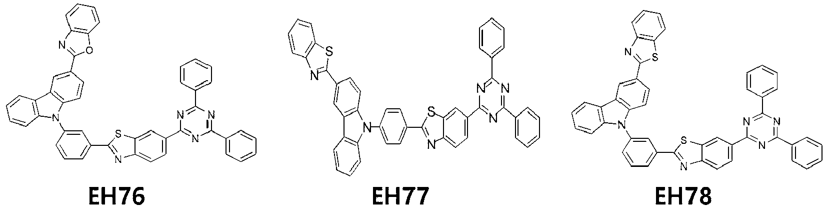

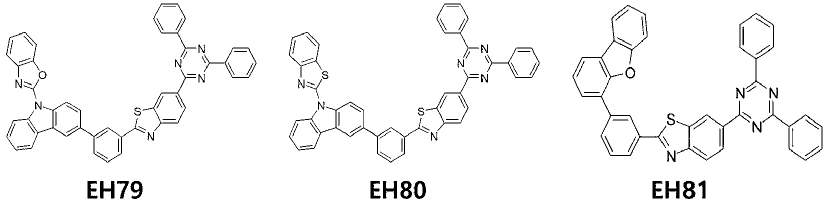

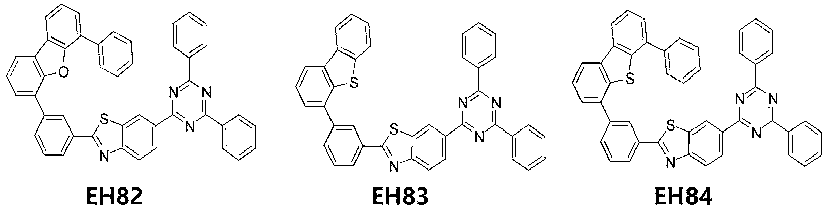

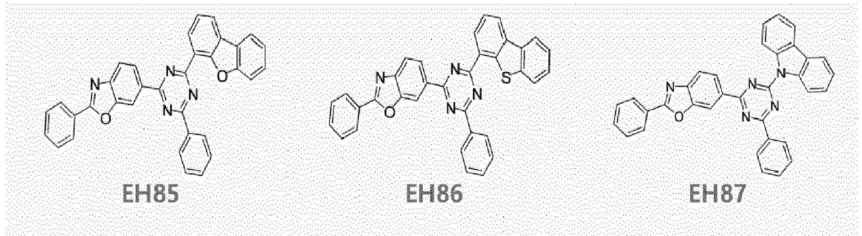

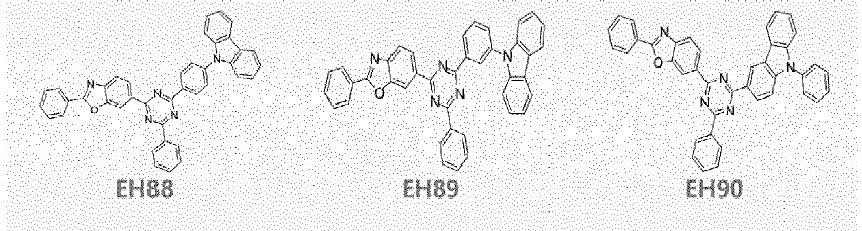

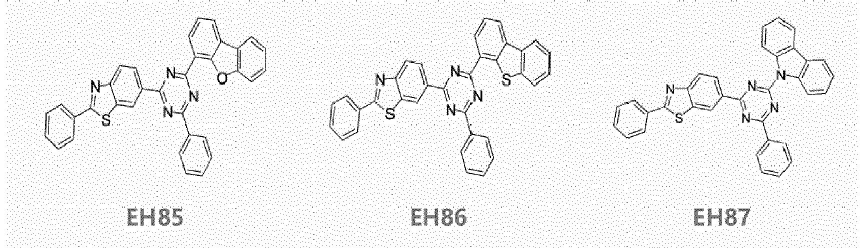

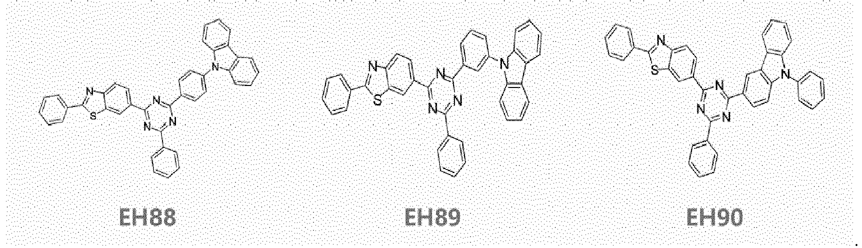

5. The organic light emitting element (200, 300, 400) of any of claims 1 to 4, wherein the organic material layer (130) includes a light emitting layer (233, 3313, 4313), and wherein the light emitting layer (233, 3313, 4313) includes the compound.

6. The organic light emitting element (200, 300, 400) of claim 5, wherein the organic material layer (130) further includes at least one of a hole injection layer (231, 3311, 4311), a hole transport layer (232, 3312, 4312), an electron transport layer (234, 3314, 4314), and an electron injection layer (235, 3315, 4315).

7. The organic light emitting element (200, 300, 400) of claim 5 or 6, wherein the compound is a host compound (2331, 33131, 43131) of the light emitting layer (233, 3313, 4313).

8. The organic light emitting element (200, 300, 400) of claim 7, wherein the light emitting layer (233, 3313, 4313) further includes a host compound different from the compound.

9. The organic light emitting element (300, 400) of any of claims 1 to 4, wherein the organic material layer (130) includes a first stack (331, 431) including a first light emitting layer (3313, 4313) and a second stack (332, 432) including a second light emitting layer (3323, 4323).

10. The organic light emitting element (300, 400) of claim 9, wherein the first light emitting layer (3313, 4313) includes the compound.

11. The organic light emitting element (300, 400) of claim 10, wherein the compound is a host compound (33131, 43131) of the first light emitting layer (3313, 4313).

12. The organic light emitting element (100, 200, 300, 400) of claim 11, wherein the first light emitting layer (3313, 4313) further includes a host compound different from the compound.
